(19) Europäisches Patentamt
European Patent Office
Office européen des brevets

(11) **EP 3 523 805 B1**

(12) **EUROPÄISCHE PATENTSCHRIFT**

(45) Veröffentlichungstag und Bekanntmachung des Hinweises auf die Patenterteilung:
**15.07.2020 Patentblatt 2020/29**

(21) Anmeldenummer: **17787369.2**

(22) Anmeldetag: **10.10.2017**

(51) Int Cl.:
*G11C 11/24* *(2006.01)*    *G11C 11/22* *(2006.01)*

(86) Internationale Anmeldenummer:
**PCT/EP2017/075872**

(87) Internationale Veröffentlichungsnummer:
**WO 2018/069359 (19.04.2018 Gazette 2018/16)**

(54) **KAPAZITIVE MATRIXANORDNUNG UND VERFAHREN ZU DEREN ANSTEUERUNG**

CAPACITIVE MATRIX ARRANGEMENT AND METHOD FOR ACTUATION THEREOF

AGENCEMENT DE MATRICE CAPACITIVE ET PROCÉDÉ DE COMMANDE DE CELUI-CI

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.10.2016 DE 102016012071**
**21.03.2017 DE 102017002739**

(43) Veröffentlichungstag der Anmeldung:
**14.08.2019 Patentblatt 2019/33**

(73) Patentinhaber:
• **Demasius, Kai-Uwe**
**04109 Leipzig (DE)**
• **Kirschen, Aron**
**01127 Dresden (DE)**

(72) Erfinder:
• **Demasius, Kai-Uwe**
**04109 Leipzig (DE)**
• **Kirschen, Aron**
**01127 Dresden (DE)**

(74) Vertreter: **Lippert Stachow Patentanwälte**
**Rechtsanwälte**
**Partnerschaft mbB**
**Krenkelstraße 3**
**01309 Dresden (DE)**

(56) Entgegenhaltungen:
**US-A1- 2008 037 324**

EP 3 523 805 B1

**Beschreibung**

Die Erfindung betrifft eine kapazitive Matrixanordnung, die ein aktives Medium, das in einer Schicht zwischen einem ersten Satz und einem zweiten Satz von jeweiligen parallelen Adressierungselektroden eingebettet ist, umfasst. Das aktive Medium ist dabei in der Lage, von elektrischen Feldern angesteuert zu werden. Es kann auch selber eine elektrische Polarisation besitzen. Dabei bilden die Adressierungselektroden des ersten Satzes Wortleitungen und die Adressierungselektroden des zweiten Satzes Bitleitungen der Matrixanordnung. Die Wortleitungen und Bitleitungen kreuzen sich an Kreuzungspunkten kreuzen vorzugsweise orthogonal. An den Kreuzungspunkten sind durch Ansteuerung der Wortleitungen und Bitleitungen auswählbare Kondensatorzellen mit dem dazwischenliegenden aktiven Medium angeordnet.

Die Erfindung betrifft auch ein Verfahren zur Ansteuerung einer kapazitiven Kondensatoranordnung, wobei eine an einem Kreuzungspunkt zwischen einer Wortleitung und einer Bitleitung befindliche Kondensatoranordnung durch eine Potentialwahl der dem Kreuzungspunkt entsprechenden auswählenden Wortleitung und der dem Kreuzungspunkt entsprechenden auswählenden Bitleitung ausgewählt wird.

In vielen Bereichen der Mikroelektronik wird eine Matrix aus Speicher-, Sensor-, Aktor- oder Bildelementen aufgebaut. Dabei müssen die einzelnen Elemente mit einer Adresse angesteuert werden, ohne dass Nachbarzellen gestört werden. Für Speicherbauelemente spielen solche Matrixanordnungen eine große Rolle, um hohe Speicherdichten und schnelle Zugriffsgeschwindigkeiten zu erzielen und einen Ersatz für den heute üblichen Flash-Speicher zu erhalten.

Dabei unterscheidet man allgemein zwischen einer passiven und einer aktiven Matrix (z.B. Willem den Boer: "Active Matrix Liquid Crystal Displays. Fundamentals and Applications" 1st Edition, Elsevier, 2005 und Temkar N. Ruckmongathan: "Addressing Techniques of Liquid Crystal Displays", Wiley, 2014).

Die passive Matrix besteht aus zueinander senkrechten Metalllinien, die die Zeilen (Bitleitungen (3)) und Spalten (Wortleitungen (2)) aufspannen. An den Kreuzungspunkten sind Zellen (4) definiert in welchen das aktive Medium (1) durch einen Stromfluss (11) oder ein elektrisches Feld angesteuert werden kann. Vorteil dieser Anordnung ist, dass sie einfach herzustellen ist und bei Speicherchips sehr hohe Dichten ($4F^2$ mit F: minimum featured size) erzielt werden können. Größter Nachteil, welcher die Anwendung einer passiven Matrix bisher verhindert ist, dass die Nachbarzellen parasitär gestört werden. Nur bei organischen ferroelektrischen Speichern kann dieses Prinzip eingesetzt werden, welches jedoch Nachteile hinsichtlich Materialverschleiß und Speicherzeit hat (EP 1 316 090 B1; EP 1 798 732 A1; US 2006/0046344 A1; US 2002/0017667 A1; US 2003/0137865 A1).

Die aktive Matrix benutzt ein aktives elektronisches Element zur Ansteuerung der einzelnen Elemente. Dies kann eine Diode oder ein Transistor sein. Die Diode würde den Vorteil einer kompakten Bauweise und bei Speicherchips einer genauso hohen Dichte wie bei einer passiven Ansteuerung ($4F^2$) bieten. Jedoch hat eine Diode bei resistiven Elementen bereits häufig das Problem, dass das Einschalt-/Ausschalt-Verhältnis zu gering ist und sich in Flüssigkristallanzeigen schlechte Kontraste erzielen lassen. Zudem wirkt eine Diode selbst wie eine Kapazität und wenn die anzusteuernden Elemente selbst Kapazitäten sind, wie z.B. bei Flüssigkristallanzeigen (US 2011/0090443 A1) /elektronischem Papier (US 2008/0043317 A1) /Mikrospiegelarray (US 5 583 688) oder ferroelektrischen Speichern (EP 1 316 090 B1) ist eine Ansteuerung schwierig (Spannungsteiler). Für resistive Speicherelementen können häufig Dioden eingesetzt werden (US 2006/0002168 A1; WO 2003/85675 A2).

Eine Transistoransteuerung (US 2003/0053351 A1; US 6 438 019) ermöglicht deutlich höhere Einschalt-/Ausschalt-Verhältnisse und außerdem können Kapazitäten geschaltet werden. Weiterhin lässt sich bei Bildschirmen der Kontrast gut steuern. Nachteile sind mehr technologische Herstellungsschritte und bei Speichern meistens ein höherer Platzbedarf.

Generell unterscheidet man bei Speichern mit Transistoransteuerung zwischen der NAND- (US 5 088 060) und der NOR-Architektur (US 7 616 497), wobei die NAND-Architektur hohe Speicherdichten ($4F^2$) ermöglicht, dafür aber deutlich längere Zugriffszeiten benötigt. Die NOR-Architektur hat einen höheren Platzbedarf ($6\text{-}8F^2$) ist aber dafür schnell (Betty Prince: "Semiconductor Memories: A Handbook of Design, Manufacture and Application", 2nd Edition, Wiley, 1995). Die Nachteile dieser zwei unterschiedlichen Architekturen bilden neben entsprechenden Speichermaterialien eines der Ursachen, wieso ein Universalspeicher, welcher SRAM, DRAM, Flash-Speicher und Festplatte vom Computer ersetzt, bisher fehlt. Daher wäre eine Architektur, welche die Vorteile der NAND- und NOR-Architektur kombiniert, wünschenswert. Ein Universalspeicher müsste mehrere Spezifikationen erfüllen, wozu eine hohe Speicherdichte zählt, eine hohe Schreib- und Lesegeschwindigkeit, sowie eine genügend hohe Anzahl an Schreib-/Lesezyklen. Ein weiteres Kriterium in Hinblick auf mobile Anwendungen ist ein niedriger Energieverbrauch. Eine mögliche alternative Technologie zu den Flash-Speichern sind ferroelektrische Speicher, wobei diese mittlerweile eine hohe Anzahl an Schreib-/Lesezyklen (1012-1015) besitzen und in etwa so schnell wie DRAM-Speicher sind. Größtes bisheriges Problem sind die Skalierbarkeit und Speicherdichte, da die ferroelektrischen Materialien wenig kompatibel zu der siliziumbasierten CMOS-Logik sind.

Neue Speichertechnologien sind auch in Hinblick auf künstliche neuronale Netzwerke wichtig. In herkömmlichen Computern sind die Verarbeitung und Speicherung von Informationen strikt getrennt, wohingegen das Gehirn eine solche Trennung nicht besitzt, und aus diesem Grund eine nichtflüchtige Speicherlösung erschaffen werden muss, welche gut in die Verarbeitungseinheiten eingebettet werden kann. Ein künstliches neuronales Netzwerk besteht aus Neuronen und Synapsen, welche Gewichte zum Beispiel in Form eines Widerstandswertes speichern. Die Neuronen, weisen meistens ein sigmoidales Übertragungsverhalten für die Aktivierungsfunktion auf, wofür häufig eine kompliziertere Transistorschaltung nötig ist (US 3476954; US 8694452), welche einen hohen Energieverbrauch besitzt und kompliziert herzustellen ist. Ebenso werden sogenannte Rectified Linear Units (ReLU) als Aktivierungsfunktionen für künstliche Neuronen verwendet.

In dem Patent DE 10 2010 045 363 B4 wurde bereits ein Halbleitersensor veröffentlicht, der ein statisches Feld zu einem Wechselfeld modulieren kann. Das Patent beinhaltet durch seine Modulation der beweglichen Ladungsträgerkonzentration in einem Halbleiter eine Steuerung eines elektrischen Feldes oder Potentials. Hierzu wird die sogenannte Debye-Länge ausgenutzt, welche die typische Abschirmlänge eines Feldes in einen Festkörper angibt, mit

$$L_D = \sqrt{\frac{\varepsilon_0 \varepsilon_r k_B T}{e^2 2n}},$$

wobei

$L_D$: Debye-Länge
$\varepsilon_0$: Elektrische Feldkonstante
$\varepsilon_r$: relative Dielektrizitätskonstante des Materials
$k_B$: Boltzmannkonstante
$T$: Temperatur
$e$: Elementarladung
$n$: bewegliche Ladungsträgerkonzentration (Elektronen- und Löcherkonzentration).

Das Feld beschreibt dabei für niedrige Felder einen exponentiellen Abfall in den Festkörper mit

$$E = E_0 \cdot e^{-\frac{x}{L_D}},$$

wobei

$E$: Elektrische Feldstärke im Festkörper
$E_0$: Feldstärke am Festkörperanfang bei x=0
$x$: Position im Festkörper.

Ist die bewegliche Ladungsträgerkonzentration sehr niedrig, so ist die Debye-Länge gering und das Feld kann den Festkörper gut durchdringen, sofern dieser wesentlich dünner als die Debye-Länge ist. Ist die bewegliche Ladungsträgerkonzentration hingegen hoch, so wird das Feld gut abgeschirmt, und wenn die bewegliche Ladungsträgerkonzentration moduliert wird, so wird das transmittierte Feld unterschiedlich stark transmittiert und in ein Wechselfeld konvertiert. Auf diese Weise wird ein Schalter für elektrische Felder realisiert.

Die Veröffentlichung der US Patentanmeldung US 2008/0037324 A1 beschreibt einen Dünnschichtspeicher entsprechend dem Oberbegriff der nachfolgend beschriebenen Erfindung.

Zusammenfassung

Aufgabe dieser Erfindung ist es deshalb, eine aktive Ansteuerung von kapazitiven Elementen in einer Matrix mit den Vorteilen einer passiven Ansteuerung (einfache Herstellung, hohe Speicherdichte, schnelle Zugriffszeit) zu ermöglichen. Gleichzeitig soll in Hinblick auf künstliche neuronale Netzwerke die Aktivierungsfunktion eines Neurons leichter modelliert werden können.

Diese Aufgabe wird durch eine Kapazitive Matrixanordnung nach Anspruch 1 und ein Verfahren zur Ansteuerung einer kapazitiven Kondensatoranordnung nach Anspruch 11 gelöst. Die abhängigen Ansprüche zeigen günstige Ausgestaltungen.

Die anordnungsseitige Lösung besteht erfindungsgemäß darin, dass bei einer kapazitiven Matrixanordnung der eingangs genannten Art die Wortleitungen zumindest in dem Bereich der Kreuzungspunkte aus einem Material mit veränderlicher Debye-Länge, d.h. einem Material mit veränderlicher beweglicher Ladungsträgerkonzentration, bestehen und zwischen aktivem Medium einem nicht-aktivem Dielektrikum, mit diesen eine Schichtanordnung bildend, angeordnet sind und die Schichtanordnung zwischen einer Bezugselektrode und den Bitleitungen angeordnet ist. In der Schichtanordnung liegt also die Reihenfolge aktives Medium - Wortleitung - nicht aktives Dielektrikum vor. Dabei kann die Schichtanordnung sowohl in einer ersten Lage mit dem aktiven Medium zur Bezugselektrode als auch in einer zweiten Lage zu den Bitleitungen weisen. Dabei ist

- eine erste Lage der Schichtanordnung so gewählt ist, dass das aktive Medium von der Wortleitung aus gesehen auf der Seite der Bezugselektrode liegt und
- alternativ eine zweite Lage der Schichtanordnung so gewählt ist, dass das aktive Medium von der Wortleitung aus gesehen, auf der Seite der Bitleitungen liegt.

In den Wortleitungen wird zum Beispiel durch Änderung der Ladungsträgerkonzentration die Transmission eines elektrischen Feldes gesteuert. Zwischen der Wortleitung und der Bezugselektrode 5, 6 ist ein nicht-aktives Dielektrikum angeordnet, welches reine Isolationszwecke erfüllt.

Die Anordnung ermöglicht auch die Detektion von elektrischen Feldern in dem aktiven Medium. Hierzu werden die Potentiale der Wortleitung, Bitleitung und der Bezugselektrode gleich gesetzt, und die Debye-Länge wird in der auswählenden Wortleitung verändert, sodass in der ausgewählten Bitleitung ein Strom durch die Influenz von Ladungen gemessen werden kann, da das elektrische Feld von dem aktiven Medium, welches sich zwischen der Wortleitung und Bezugselektrode befindet, einen Wechsel von Transmission zur Abschirmung oder umgekehrt vollführt. Befindet sich das aktive Medium zwischen Bitleitung und Wortleitung, so muss der Strom in der Streifenbezugselektrode gemessen werden.

Die hier skizzierte Erfindung ermöglicht die Steuerung einer kapazitiven Kopplung in einer Matrixanordnung. Somit kann ein Feld punktuell zu Ansteuerungszwecken erzeugt und gleichzeitig gemessen werden. Diese Ansteuerung erfolgt ohne Transistoren, was Vorteile der passiven Matrix mit Vorteilen der aktiven Matrix kombiniert. Im Hinblick auf Speichertechnologien werden der Vorteil der NAND-Architektur mit seiner hohen Speicherdichte und der Vorteil der NOR-Architektur mit hoher Zugriffsgeschwindigkeit kombiniert. Die Speicherdichte beträgt $4F^2$, wie bei einer passiven Matrix oder der NAND-Architektur, und die hohe Zugriffsgeschwindigkeit resultiert aus der Verwendung metallischer Bitleitungen und Bezugselektroden, welche einen geringeren Widerstand besitzen, als Transistoren, womit die Zeitkonstante zum Aufladen der Bitleitung und der Bezugselektroden reduziert wird.

Im Wesentlichen ist die Herstellung fast genauso einfach, wie bei einer passiven Matrix, ohne, dass jedoch eine parasitäre Kopplung zu Nachbarzellen entsteht. Die Steuerung des transmittierten elektrischen Feldes kann adaptiv erfolgen, was bei Displays wichtig für den Kontrast ist und bei Speichern mehrstufige Speicherzellen ermöglichen könnte.

Die Bezugselektrode kann ganzflächig ausgebildet sein.

Es ist aber auch möglich, dass die Bezugselektrode aus mehreren streifenförmigen Streifenbezugselektroden besteht. Dies eröffnet die Möglichkeit, dass die Streifenbezugselektroden den Bitleitungen entsprechend ausgebildet und einzeln ansteuerbar sind.

Eine den Bitleitungen entsprechende Ausbildung der Streifenbezugselektroden bedeutet im Wesentlichen, dass sie eine Breite in gleicher Größenordnung und Anzahl aufweisen. Vorzugsweise können die Streifenbezugselektroden in gleicher Richtung wie die Bitleitungen verlaufen. Es ist aber auch möglich, dass sich diese kreuzen, vorzugsweise orthogonal.

In einer Ausgestaltung ist vorgesehen, dass die Wortleitungen aus einem Halbleiter bestehen und mit p- und n-dotierten Gebieten, versehen sind, wobei die Höhe der Dotierung so gewählt wird, dass die Fermi-Niveaus der p- und n-dotierten Gebiete gleichen Abstand zu dem Fermi-Niveau der Wortleitungen besitzen und das Bändermodell des so entstehenden psn-Überganges eine Symmetrie besitzt.

Hierbei kann vorgesehen sein, dass die p- und n-dotierten Gebiete entweder jeweils seitlich Längserstreckung der jeweiligen Wortleitung oder an jeweils einer Stirnseite angeordnet sind.

Um zu vermeiden, dass immer eine komplette Wortleitung mit Ladungsträgern verarmt oder angereichert werden muss, was sich als Energie- und Zeitaufwendig herausstellt, ist in einer weiteren Ausgestaltung vorgesehen, dass sich die Streifenbezugselektroden und die Bitleitungen kreuzen und an den Kreuzungspunkten die Streifenbezugselektrode über das p-dotierte Gebiet und die Bitleitung über das n-dotierte Gebiet oder die Streifenbezugselektrode über das n-dotierte Gebiet und die Bitleitung über das p-dotierte Gebiet jeweils mit der Wortleitung verbunden ist. Hierdurch wird auch vermieden, dass die Debye-Längen-Änderung und die Spannung zwischen Bezugselektrode und Bitleitung getrennt eingestellt werden muss.

Es ist auch möglich, dass die Wortleitungen aus einem Halbleiter bestehen und mit unterschiedlichen Metallgebieten, versehen sind, die Schottky-Kontakte ausbilden, wobei die Austrittsarbeit der Metalle so gewählt wird, dass die Abstände der Fermi-Niveaus zwischen den Metallgebieten und dem Halbleiter identisch sind und das Bändermodell symmetrisch ist. Hierbei sind die Metallgebiete entweder jeweils seitlich Längserstreckung der jeweiligen Wortleitung oder an jeweils einer Stirnseite angeordnet.

Es ist auch möglich, dass ein Material mit einem Metall-Isolator-Übergang für die Wortleitungen zum Einsatz kommt.

In einer Ausgestaltung der kapazitiven Matrixanordnung ist das aktive Medium ein elektrisch polarisierbares dielektrisches Speichermaterial zur Speicherung von Daten, insbesondere von digitalen Daten.

Es können auch mehrere erfindungsgemäße Matrixanordnungen übereinander gestapelt werden, wobei die Streifenbezugselektroden gleichzeitig die Bitleitungen für die darüber liegende Zelle bilden können. Diese Anordnung ist vor allem für Speicheranwendungen vorteilhaft, da so die Speicherdichte erheblich erhöht werden könnte.

Das aktive Medium kann auch ein flüssigkeitsbasiertes oder elektrophoretisches Anzeigemittel sein.

Hierbei ist es möglich, dass das aktive Medium ein

Flüssigkristall ist, welcher seine Polarisationsrichtung ändert und zur Anzeige von Informationen dient.

Es ist hierbei aber auch möglich, dass das aktive Medium aus Mikrokapseln zur elektrophoretischen Ansteuerung und Anzeige von Informationen besteht. Dieses Prinzip kann bei sogenanntem elektronischem Papier zum Einsatz kommen.

Das aktive Medium kann auch aus Flüssigkeitstropfen bestehen und die Elektrobenetzung kann von diesen gesteuert werden.

Die kann in der EWOD (Electrowetting on dielectric) Technologie in der Mikrofluidik Verwendung finden.

Auch mechanische Aktoren können als aktives Medium eingesetzt werden, was zum Beispiel in Mikrospiegelarrays angewendet werden kann.

Es kann auch vorgesehen sein, dass bewegliche Ionen in einem Festkörper als aktives Medium zur Speicherung digitaler Informationen verwendet werden. Hierbei kann ein Ferroelektrikum als Speichermaterial Verwendung finden.

Eine weitere Ausführung der kapazitiven Matrixanordnung sieht vor, dass die Wortleitungen aus Strontiumtitanat oder Titandioxid bestehen.

In einer Ausführung ist vorgesehen, dass die Matrixanordnung eine Modellierung der Aktivierungsfunktion eines künstlichen Neurons mit einem sigmoidalen Transmissionsverhalten der Wortleitungen oder mit einer Nichtlinearität des erzeugten elektrischen Feldes einschließt. Dabei weisen die Wortleitungen ein sigmoidales Transmissionsverhalten zur Modellierung einer Aktivierungsfunktion eines Neurons auf. Ebenso können die Nichtlinearität der Wortleitungen zur Modellierung der Rectified Linear Units (ReLU) verwendet werden.

Die erfindungsgemäße Aufgabenstellung wird auch durch ein Verfahren der eingangs genannten Art gelöst, wobei in der auszuwählenden Kondensatorzelle ein elektrisches Feld erzeugt wird, indem bei einem Einstellen des Zustandes des aktiven Mediums

- in der auszuwählenden Kondensatorzelle ein elektrisches Feld erzeugt wird, indem

  • im Falle der ersten Lage der Schichtenordnung eine Potentialdifferenz zwischen auswählender Bitleitung und der Bezugselektrode (5, 6) angelegt wird und das Potential der auswählenden Wortleitung identisch zur Bezugselektrode (5, 6) gewählt wird,

  • oder im Falle der zweiten Lage der Schichtanordnung das Potential der Wortleitung identisch zur Bitleitung gewählt wird, und dass in der auswählenden Wortleitung eine lange Debye-Länge, d.h. eine so niedrige bewegliche Ladungsträgerkonzentration, dass ein genügend starkes Feld transmittiert wird, erzeugt wird, dass in dem aktiven Medium eine Wirkung erzeugt wird, sodass am Kreuzungspunkt zur auswählenden Bitleitung ein elektrisches Feld transmittiert wird, wobei an den nicht-auswählenden Wortleitungen eine kurze Debye-Länge, d.h. eine so hohe bewegliche Ladungsträgerkonzentration, dass in dem aktiven Medium keine Wirkung erzielt wird, und damit eine schlechte Transmission eingestellt wird,

- oder zwischen auswählender Bitleitung und Bezugselektrode (5, 6) keine Potentialdifferenz vorliegt, und das Potential der auswählenden Wortleitung unterschiedlich zur Bezugselektrode (5, 6) und Bitleitung gewählt wird und

  • die Debye-Länge der Wortleitung kurz gewählt wird, und die Feldlinien des elektrischen Feldes jeweils hauptsächlich an der Wortleitung enden, sodass in dem aktiven Medium eine Wirkung einsetzt, wobei an die nicht-ausgewählten Wortleitungen eine lange Debye-Länge und eingestellt wird, so dass in dem aktiven Medium eine Wirkung einsetzt oder

  • die Debye-Länge in den Wortleitungen konstant gehalten wird und die Potentiale an den Wortleitungen, Bitleitungen und Streifenbezugselektroden so gewählt werden, dass die Potentialdifferenz zwischen Bitleitung und Wortleitung an der ausgewählten Kondensatorzelle als volle Spannung vorliegt und an den nicht-ausgewählten Kondensatorzellen ein Teil, vorzugsweise 1/3 der vollen Spannung vorliegt und die Nichtlinearität des erzeugten Feldes zur Unterdrückung des Feldes in den nicht-ausgewählten Kondensatorzellen sorgt.

und indem bei einem Feststellen des Zustandes des aktiven Mediums in der auszuwählenden Kondensatorzelle ein elektrisches Feld gemessen wird, indem die Potentiale der Bitleitungen, der Bezugselektroden (5, 6) und der Wortleitungen identisch gewählt werden und

- im Falle der ersten Lage der Schichtanordnung, ein Strom in der ausgewählten Bitleitung gemessen wird, welcher während der Änderung der Debye-Länge in der ausgewählten Wortleitung erzeugt wird, und

- im Falle der zweiten Lage der Schichtanordnung der Strom in einer dem Kreuzungspunkt entsprechenden Streifenbezugselektrode gemessen wird.

Zu bemerken ist, dass sich ein Material bei einer kurzen Debye-Länge im hier dargestellten Sinne quasi metallisch verhält und bei einer kurzen Debye-Länge im hier dargestellten Sinne quasi wie ein Isolator.

Im Folgenden beschreibt $\Phi_R$ das Potential der Bezugselektrode $\Phi_B$ das Potential der Bitleitung und $\Phi_W$ das Potential der Wortleitung.

Um nun in der Matrix in dem aktiven Medium punktuell ein elektrisches Feld zu erzeugen, gibt es, wie oben beschrieben, zwei Möglichkeiten:

Zwischen der ausgewählten Bitleitung und Bezugselektrode liegt in diesem Fall eine Potentialdifferenz ($\Phi_B \neq \Phi_R$) vor, sodass ein elektrisches Feld erzeugt wird. Wenn in der auswählenden Wortleitung nun eine solche Debye-Länge vorliegt, dass das elektrische Feld gut transmittiert wird, so wird an dem Kreuzungspunkt zwischen der auswählenden Wortleitung und der auswählenden Bitleitung ein elektrisches Feld zu der Bezugselektrode transmittiert, sodass dieses in einem aktiven Medium etwas bewirken kann (z.B. Bei einem Ferroelektrikum eine Polarisationsänderung, die remanent bleibt). Wird in den nicht-auswählenden Wortleitungen nun eine kurze Debye-Länge eingestellt, d.h. eine so hohe bewegliche Ladungsträgerkonzentration, dass in dem aktiven Medium keine Wirkung erzielt wird, so wird das elektrische Feld, welches zwischen der ausgewählten Bitleitung und der Bezugselektrode vorliegt, unterbrochen. Dabei muss beachtet werden, dass sich die Wortleitung in diesem Falle nahezu metallisch verhält und bei Vorliegen einer Potentialdifferenz zwischen Wortleitung und Bezugselektrode bzw. Bitleitung ein elektrisches Feld ausbilden würde. Liegt die erste Lage der Schichtanordnung vor, d.h. ist das aktive Medium zwischen Wortleitung und Bezugselektrode angeordnet, so muss das Potential der Wortleitung entsprechend identisch zur Bezugselektrode gewählt werden ($\Phi_B = \Phi_R$). Das sich ausbildende Feld zwischen Wortleitung und Bitleitung in dem nicht-aktiven Dielektrikum stört nicht weiter, da das nicht-aktive Dielektrikum keine Funktion wahrnimmt, außer einer Isolation. Andernfalls, wenn die zweite Lage der Schichtanordnung vorhanden ist, d.h. sich das aktive Medium zwischen Wortleitung und Bitleitung befindet, so ist das Potential der Wortleitung identisch zu der Bitleitung zu wählen ($\Phi_W = \Phi_B$).

2. Zwischen der ausgewählten Bitleitung und Bezugselektrode kann auch ein identisches Potential vorliegen ($\Phi_B = \Phi_R$), wobei das elektrische Feld in dem aktiven Medium diesmal durch eine kurze Debye-Länge in der ausgewählten Wortleitung erzeugt wird. Die Wortleitung verhält sich dann wieder nahezu metallisch und wenn diese eine Potentialdifferenz zur Bitleitung und damit auch zur Bezugselektrode 5, 6 besitzt ($\Phi_W \neq \Phi_B$), so wird in dem aktiven Medium ein elektrisches Feld generiert. Wird nun an die nicht-ausgewählte Wortleitung eine lange Debye-Länge eingestellt, d.h. eine so niedrige bewegliche Ladungsträgerkonzentration, dass ein genügend starkes Feld transmittiert wird, dass in dem akiven Medium eine Wirkung einsetzt, sodass das Potential der Bitleitung und der Bezugselektrode 5, 6 gut transmittiert wird, so verschwindet das elektrische Feld aus dem aktiven Medium. Das Wortleitungspotential kann in diesem Fall beliebig gewählt werden, da dieses durch die Transmission keine Wirkung mehr erzielt. Das heißt die Debye-Länge zwischen Auswahl und nicht-Auswahl verhält sich hier genau umgekehrt, im Vergleich zu 1.

In einer weiteren Ausführung des Verfahrens ist vorgesehen, dass die Ansteuerung der kompletten Matrix

- im Falle der ersten Lage der Schichtanordnung in der Weise erfolgt, dass bei Vorliegen einer Potentialdifferenz zwischen einer dem Kreuzungspunkt entsprechenden Streifenbezugselektrode und der entsprechenden Bitleitung an die nicht-auswählenden Wortleitungen und nicht-ausgewählten Streifenbezugselektroden ein identisches Potential wie an die auswählende Bitleitung angelegt wird und die nicht-auswählenden Bitleitungen mit identischem Potential wie die entsprechende Streifenbezugselektrode versehen wird, und

- im Falle der zweiten Lage der Schichtanordnung in der Weise erfolgt, dass bei Vorliegen einer Potentialdifferenz zwischen einer dem Kreuzungspunkt entsprechenden Streifenbezugselektrode und der entsprechenden Bitleitung an die nicht-auswählenden Wortleitungen und nicht-auswählenden Bitleitungen ein identisches Potential wie an die entsprechende Streifenbezugselektrode angelegt wird und die anderen Streifenbezugselektroden mit identischem Potential wie die auswählende Bitleitung versehen werden.

Alternativ dazu kann vorgesehen sein, dass die Ansteuerung der kompletten Matrix in der Weise erfolgt, dass bei Vorliegen keiner Potentialdifferenz zwischen ausgewählter Bitleitung und ausgewählter Streifenbezugselektrode (6), wobei die Streifenbezugselektroden und Bitleitungen parallel angeordnet werden, die nicht-auswählenden Bitleitungen und nicht-auswählenden Streifebezugselektroden auf dasselbe Potential, wie die ausgewählte Wortleitung gelegt werden und das Potential der nicht-auswählenden Wortleitungen beliebig gewählt werden kann.

Sofern psn-Übergänge vorgesehen sind, kann an die psn-Übergänge eine Sperrspannung zur Verarmung der beweglichen Ladungsträgerkonzentration in den Wortleitungen angelegt werden, sofern eine lange Debye-Länge gewünscht wird und eine Durchlassspannung zur Anreicherung der beweglichen Ladungsträgerkonzentration in den Wortleitungen angelegt werden, sofern eine kurze Debye-Länge gewünscht wird, wobei eine antisymmetrische Spannung jeweils an die p- und n-Gebiete angelegt wird.

Weiterhin kann ein Stromfluss durch die auswählende Wortleitung eine leichte Temperaturerhöhung bewirken und ein Metall-Isolator-Übergang eine Änderung der beweglichen Ladungsträgerkonzentration in der auswählenden Wortleitung auslösen.

Detaillierte Beschreibung

Nachfolgend soll die Erfindung anhand von Ausführungsbeispielen näher erläutert werden. In den zugehörigen Zeichnungen zeigt

Fig. 1     eine Ansicht der Matrix von oben mit Streifenbezugselektrode,

Fig. 2     eine Ansicht der Matrix von oben mit ganzflächiger Bezugselektrode,

Fig. 3     eine Querschnittsansicht der Matrix mit Streifenbezugselektrode,

Fig. 4     eine Querschnittsansicht der Matrix mit ganzflächiger Bezugselektrode,

Fig. 5    Potentialverhältnisse bei einer Potentialdifferenz zwischen ausgewählter Bitleitung und Bezugselektrode für die ausgewählte und nichtausgewählte Wortleitung,

Fig. 6    Potentialverhältnisse bei keiner Potentialdifferenz zwischen Bitleitung und Bezugselektrode für die ausgewählte und nichtausgewählte Wortleitung,

Fig. 7    Potentialverhältnisse zum Messen des elektrischen Feldes in dem aktiven Medium,

Fig. 8    Günstige Potentialverhältnisse der kompletten Matrix bei Vorliegen einer Potentialdifferenz zwischen ausgewählter Bitleitung und Bezugselektrode (aktives Medium zwischen Bezugselektrode (6) und Wortleitung (2) angeordnet),

Fig. 9    Günstige Potentialverhältnisse der kompletten Matrix bei Vorliegen keiner Potentialdifferenz zwischen ausgewählter Bitleitung und Bezugselektrode (aktives Medium zwischen Bezugselektrode (6) und Wortleitung (2) angeordnet),

Fig. 10a    eine Matrix mit psn-Übergängen in Längserstreckung der Wortleitungen seitlich zu diesen,

Fig. 10b    eine Matrix mit psn-Übergängen an den Stirnseiten der Wortleitungen

Fig. 11    eine Matrix mit Metall-Isolator-Übergang Material für die Wortleitung,

Fig. 12    ein Übertragungsverhalten des transmittierten Feldes der Wortleitung und

Fig. 13    eine Querschnittsansicht einer dreidimensionalen Stapelung der Matrix

Fig. 14    eine Ansicht der Matrix mit konstanter Debye-Länge in der Wortleitung,

Fig. 15    eine Nichtlinearität des erzeugten Feldes,

Fig. 16    eine Matrix mit p- und n-dotierten Streifen und

Fig. 17    eine Querschnittsansicht der Matrix nach Anspruch 1.

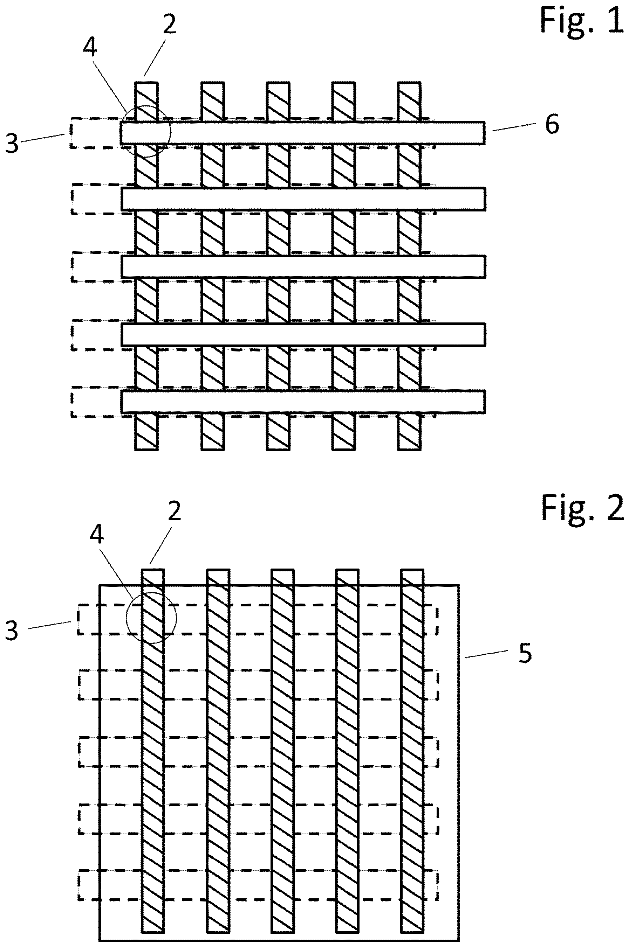

Die Fig. 1 bis Fig. 4 zeigen ein kapazitive Matrixanordnung, mit einem aktiven Medium 1. Das aktive Medium 1 ist dadurch charakterisiert, dass mit elektrischen Feldern angesteuert werden kann oder selber eine elektrische Polarisation besitzt. Das aktive Medium 1 ist in einer Schicht zwischen einem ersten Satz und einem zweiten Satz von jeweiligen parallelen Adressierungselektroden eingebettet ist, wobei die Adressierungselektroden des ersten Satzes Wortleitungen 2 und die Adressierungselektroden des zweiten Satzes Bitleitungen 3 der Matrixanordnung bilden.

Die Wortleitungen 2 und die Bitleitungen 3 kreuzen sich an Kreuzungspunkten. An den Kreuzungspunkten sind durch Ansteuerung der Wortleitungen 2 und Bitleitungen 3 auswählbare Kondensatorzellen 4 mit dem dazwischenliegenden aktiven Medium 1 angeordnet.

Im Folgenden beschreibt $\Phi_R$ das Potential der Bezugselektrode 5, 6, $\Phi_B$ das Potential der Bitleitung 3 und $\Phi_W$ das Potential der Wortleitung 2.

Um nun in der Matrix in dem aktiven Medium 1 punktuell ein elektrisches Feld 13 zu erzeugen, gibt es, wie oben bereits dargestellt, zwei mögliche Verfahren:

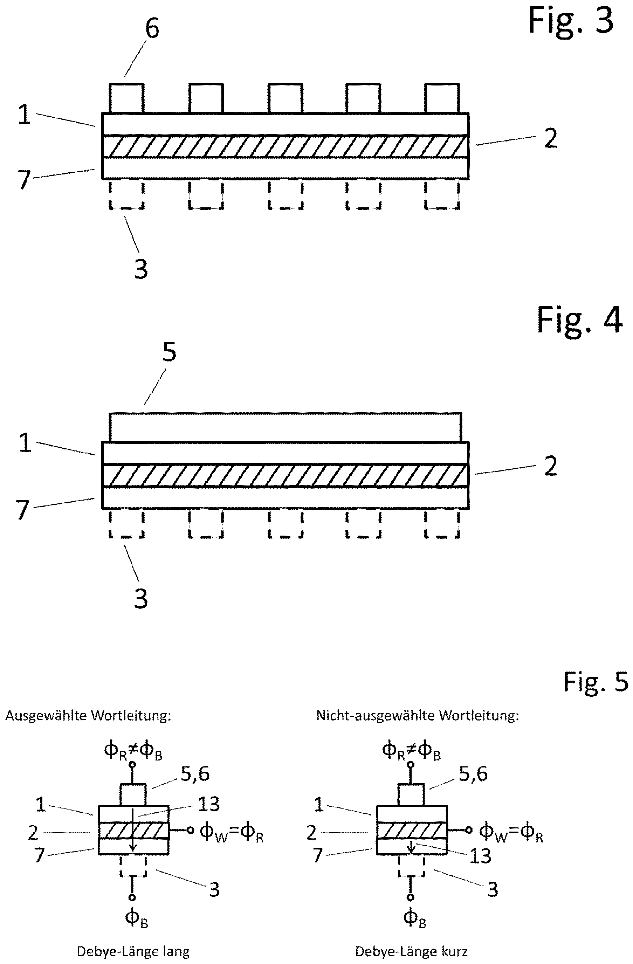

Wie in Fig. 5 dargestellt, liegt zwischen der ausgewählten Bitleitung 3 und Bezugselektrode 5, 6 in diesem Fall eine Potentialdifferenz $\Phi_B \neq \Phi_R$ vor, sodass ein elektrisches Feld 13 erzeugt wird, wie im ersten Teil des Anspruches 2 beschrieben. Wenn in der ausgewählten Wortleitung 2 nun eine solche Debye-Länge vorliegt, dass das elektrische Feld 13 gut transmittiert wird, so wird an dem Kreuzungspunkt zwischen der ausgewählten Wortleitung 2 und der ausgewählten Bitleitung 3 ein elektrisches Feld 13 zu der Bezugselektrode 5, 6 transmittiert, sodass dieses in einem aktiven Medium 1 etwas bewirken kann z.B. bei einem Ferroelektrikum eine Polarisationsänderung, die remanent bleibt. Wird in den nicht-ausgewählten Wortleitungen 2 nun eine kurze Debye-Länge eingestellt, so wird das elektrische Feld 13 welches zwischen der ausgewählten Bitleitung 3 und der Bezugselektrode 5, 6 vorliegt unterbrochen. Dabei muss beachtet werden, dass sich die Wortleitung 2 in diesem Falle nahezu metallisch verhält und bei Vorliegen einer Potentialdifferenz zwischen Wortleitung 2 und

Bezugselektrode 5, 6 bzw. Bitleitung 3 ein elektrisches Feld 13 ausbilden würde. Ist das aktive Medium 1 somit zwischen Wortleitung 2 und Bezugselektrode 5, 6 angeordnet, so muss das Potential der Wortleitung 2 entsprechend identisch zur Bezugselektrode 5, 6 gewählt werden $\Phi_B = \Phi_R$. Das sich ausbildende Feld zwischen Wortleitung und Bitleitung in dem nicht-aktiven Dielektrikum stört nicht weiter, da das nicht-aktive Dielektrikum keine Funktion wahrnimmt, außer einer Isolation. Andernfalls, wenn sich das aktive Medium 1 zwischen Wortleitung 2 und Bitleitung 3 befindet nicht in Fig. 5 dargestellt, so ist das Potential der Wortleitung 2 identisch zu der Bitleitung 3 zu wählen $\Phi_W = \Phi_B$.

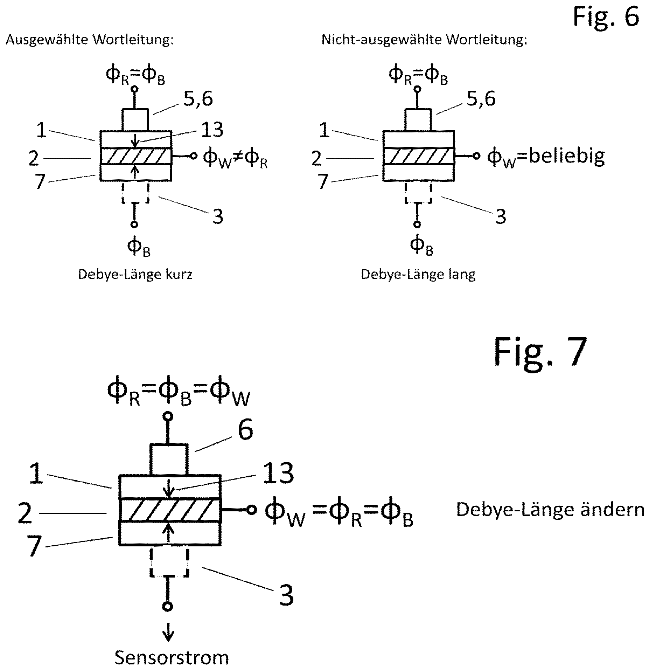

Wie in Fig. 6 dargestellt, kann zwischen der ausgewählten Bitleitung 3 und Bezugselektrode 5, 6 auch ein identisches Potential vorliegen $\Phi_B = \Phi_R$, wobei das elektrische Feld 13 in dem aktiven Medium 1 diesmal durch eine kurze Debye-Länge in der ausgewählten Wortleitung 2 erzeugt wird. Die Wortleitung 2 verhält sich dann wieder nahezu metallisch und wenn diese eine Potentialdifferenz zur Bitleitung 3 und damit auch zur Bezugselektrode 5, 6 besitzt $\Phi_W \neq \Phi_B$, so wird in dem aktiven Medium 1 ein elektrisches Feld 13 generiert. Wird nun an die nicht-ausgewählte Wortleitung 2 eine lange Debye-Länge eingestellt, sodass das Potential der Bitleitung 3 und der Bezugselektrode 5, 6 gut transmittiert wird, so verschwindet das elektrische Feld 13 aus dem aktiven Medium 1. Das Wortleitungspotential kann in diesem Fall beliebig gewählt werden, da dieses durch die Transmission keine Wirkung mehr erzielt. Das heißt die Debye-Länge zwischen Auswahl und nicht-Auswahl verhält sich hier genau umgekehrt, im Vergleich zum vorstehend dargestellten ersten Fall.

Die Ansteuerung der kompletten Matrix kann auf zwei verschiedene Weisen erfolgen, je nachdem ob eine Potentialdifferenz zwischen ausgewählter Bitleitung 3 und Streifenbezugselektrode 6 vorliegt oder nicht.

In den Ausführungsbeispielen wird eine günstige Wahl der nicht ausgewählten Potentiale vorgestellt, um die Anzahl der Kapazitäten, welche geladen werden müssen, zumindest auf der ausgewählten Bitleitung 3 und ausgewählten Bezugselektrode 6 zu reduzieren. Dabei müssen Aufladungen in dem aktiven Medium 1 außer in der ausgewählten Kondensatorzelle 4 gänzlich vermieden werden. Wenn gleichzeitig die Aufladungen in dem nicht-aktiven Dielektrikum 7 entlang der ausgewählten Bitleitung 3 und Wortleitung 2 vermieden wird, so kann die Zeitkonstante zum Aufladen der ausgewählten Kondensatorzelle 4 reduziert werden, was bei Speichern einen Geschwindigkeitsvorteil bedeuten würde.

In Fig. 7 ist die Detektion von elektrischen Feldern in dem aktiven Medium dargestellt. Hierzu werden die Potentiale der Wortleitung 2, Bitleitung 3 und der Bezugselektrode 5, 6 gleich gesetzt, und die Debye-Länge wird in der auswählenden Wortleitung 2 verändert, sodass in der ausgewählten Bitleitung 3 ein Strom durch die Influenz von Ladungen gemessen werden kann, da das elektrische Feld 13 von dem aktiven Medium 1, welches sich zwischen der Wortleitung 2 und Bezugselektrode 5, 6 befindet, einen Wechsel von Transmission zur Abschirmung oder umgekehrt vollführt. Befindet sich das aktive Medium 1 zwischen Bitleitung 3 und Wortleitung 2, so muss der Strom in der Streifenbezugselektrode 6 gemessen werden.

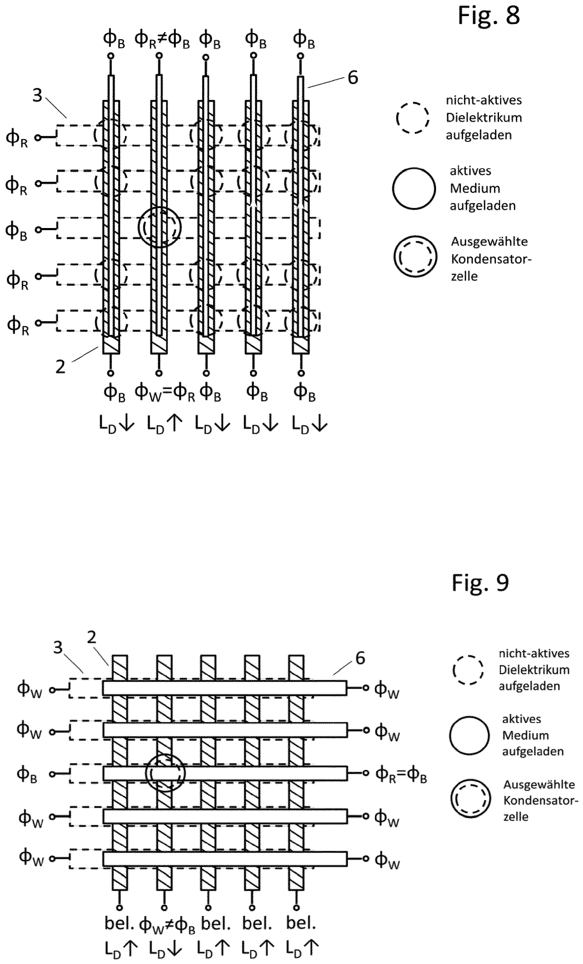

In Fig. 8 wird zunächst ein Ausführungsbeispiel für den Fall einer Potentialdifferenz zwischen Bitleitung 5 und Bezugselektrode 6 vorgestellt. Das aktive Medium 1 befindet sich zwischen Wortleitung 2 und Bezugselektrode 6. Die Bezugselektroden 6 sind parallel zur Wortleitung 2 angeordnet und an die nicht-ausgewählten Wortleitungen 2 und nicht-ausgewählten Streifenbezugselektroden 6 wird ein identisches Potential $\Phi_B$, wie an die ausgewählte Bitleitung 6 angelegt. Damit wird zum einen sichergestellt, dass das aktive Medium 1 in den nicht-ausgewählten Wortleitungen 2 und nicht-ausgewählten Bezugselektroden 6 nicht aufgeladen wird, da beide identisches Potential $\Phi_B$ haben. Gleichzeitig besitzen die nicht-ausgewählten Wortleitungen 2 ein identisches Potential, wie die ausgewählte Bitleitung 3, wodurch eine Aufladung zwischen Wortleitung 2 und ausgewählter Bitleitung 3 in dem nicht-aktiven Dielektrikum 7 vermieden wird. Somit wird die ausgewählte Bitleitung 3 sich nur an der ausgewählten Kondensatorzelle 4 aufladen dort wo die Wortleitung 2 ausgewählt ist. Die Aufladung entlang der ausgewählten Wortleitung 2, welche eine gute Transmission besitzt, wird dadurch vermieden, dass das Potential der nicht-ausgewählten Bitleitungen 3 identisch zu dem der ausgewählten Bezugselektrode $\Phi_R$ gewählt wird. Damit liegt keine Potentialdifferenz zwischen nicht-ausgewählter Bitleitung 3 und ausgewählter Bezugselektrode 6 vor.

Auf diese Weise findet eine Aufladung entlang der gewählten Bezugselektrode 6 und der gewählten Bitleitung 3 nur dort statt, wo das aktive Medium 1 punktuell verändert werden soll (in Fig. 8 der gestrichelte und durchgängige Kreis).

Wie in Fig. 8 durch die gestrichelten schwarzen Kreise dargestellt, findet wohl eine Aufladung in dem nicht-aktiven Dielektrikum an einigen Stellen außerhalb der ausgewählten Bezugselektrode 6 und ausgewählten Bitleitung 3 statt. Diese Aufladung stört jedoch nicht weiter und könnte durch hohe Serienwiderstände vermindert werden, um den Energieverbrauch zu reduzieren.

In Fig. 9 wird ein weiteres Ausführungsbeispiel dargestellt. Die Streifenbezugselektroden 6 und Bitleitungen 3 können hierbei parallel ausgerichtet sein. Um eine unnötige Aufladung entlang der ausgewählten Wortlinie 2 zu vermeiden, werden nicht-ausgewählte Bitleitungen 3 und nichtausgewählte Bezugselektroden 6 auf dasselbe Potential $\Phi_W$, wie die ausgewählte Wortlinie 2 gelegt. Damit wird sowohl die Aufladung in dem aktiven Medium 1 als auch nicht-aktiven Dielektrikum 7 vermieden. In diesem Verfahren findet ausschließlich eine Aufladung in der ausgewählten Kondensatorzelle 4 statt, was Vorteile gegenüber Anspruch 4 bringen würde.

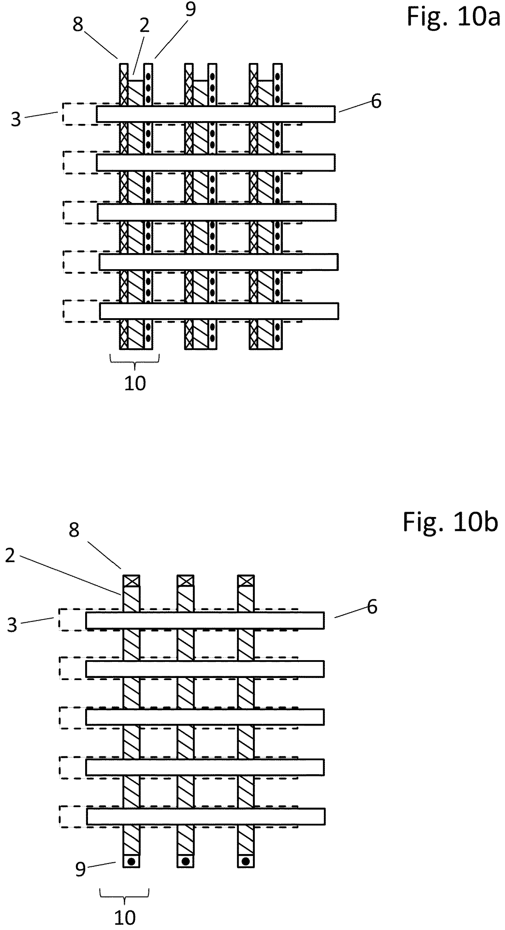

Wie in Fig. 10a und Fig. 10b dargestellt, kann die erfindungsgemäße kapazitive Matrixanordnung mittels psn-Übergängen aufgebaut werden. Die Wortleitungen 2 können aus einem schwach dotierten Halbleiter bestehen und sind mittels abwechselnder p- und n-Gebiete 8, 9 miteinander verbunden. Dabei wird das elektrische Feld in dem schwach dotierten Bereich transmittiert. Dabei sollte die Höhe der Dotierung in den p- und n-Gebieten 8, 9 so hoch gewählt werden, dass der komplette Übergang ein symmetrisches Bänderschema aufweist und mittels antisymmetrischer Spannungen erfolgen kann, wodurch ein Ausgleich erreicht wird und in dem schwach dotierten Gebiet kein Störfeld generiert wird. Wird der psn-Übergang in Sperrrichtung betrieben, so wird die Wortleitung 2 verarmt und das senkrechte Feld gut transmittiert, in Durchlassrichtung würde das Feld gut abgeschirmt werden.

Gemäß Fig. 10a ist das jeweilige p-dotierte Gebiet 8 parallel zur Längserstreckung der Wortleitung 2 auf der einen Seite und das n-dotierte Gebiet 9 ebenfalls parallel zur Längserstreckung der Wortleitung 2 aber auf der anderen Seite der Wortleitung 2 angeordnet.

Gemäß Fig. 10b ist das jeweilige p-dotierte Gebiet 8 an der einen Stirnseite der Wortleitung 2 und das jeweilige n-dotierte Gebiet 9 an der anderen Stirnseite der Wortleitung 2 angeordnet.

Ebenso können Schottky-Kontakte verwendet werden, welche z.B. bei Speichern einen deutlich schnelleren Datenzugriff ermöglichen.

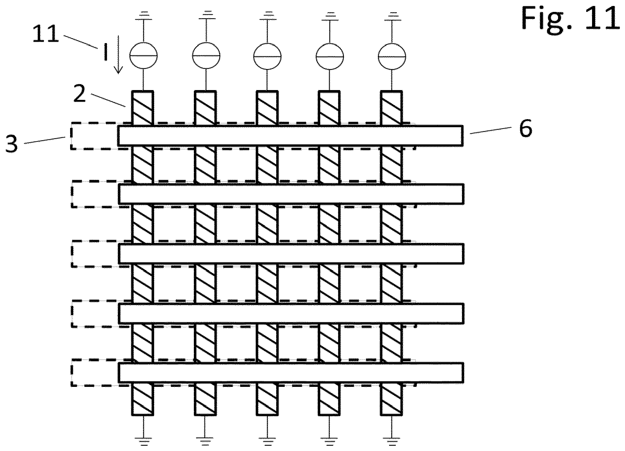

Wie in Fig. 11 dargestellt kann ein schneller Datenzugriff und zusätzlich reduzierten Energieverbrauch mit einem Metall-Isolator-Übergang in der Wortleitung 2 erzielt werden. Dazu wird durch die Wortleitungen 2 ein Strom geleitet, welcher zu einer leichten Temperaturerhöhung führt und damit einen Übergang vom metallischen zum isolierenden Zustand bewirkt. Weiterer Vorteil dieser Anordnung ist, dass die Störspannungen, im Gegensatz zu nicht perfekt symmetrischen psn- oder Schottky-Kontakten sehr gering sind. In Bezug auf ferroelektrische Speicher wird das aktive Medium mit einem Ferroelektrikum ersetzt. Zudem wäre der Weg frei zu einer 3D Integration, indem mehrere solcher Matrix-Strukturen übereinander gestapelt werden. Weiterhin ist das Auslesen des Polarisationszustandes nicht destruktiv, da die Struktur gleichzeitig als Felddetektor dient. Das destruktive Auslesen war eines der großen Probleme bei konventionellen ferroelektrischen Speichern. Die Zugriffsgeschwindigkeit bei heutigen ferroelektrischen Speichern ist vor allem durch den Widerstand der Transistoren limitiert. Mit metallischen Bitleitungen 3 und Bezugselektroden 5, 6 wäre dieser Widerstand deutlich niedriger. Zudem könnte die Modulation des Halbleiters mit Schottky-Kontakten erfolgen, die sehr schnell reagieren. Mittels geschickten Ansteuerung der Matrix können die Kapazitäten der Bitleitungen 3 und der Bezugselektroden 6 reduziert werden. Diese drei Aspekte zusammen könnten zu schnelleren Zugriffs- und Schreibzeiten führen, als bei konventionellen FeRAMs. Wird als Halbleitermaterial zusätzlich SrTiO3 oder TiO2 verwendet, so ergeben sich Vorteile durch die höhere Dielektrizitätskonstante und ähnlichen Kristallstrukturen wie die der Ferroelektrika Perovskite, wodurch das Problem mit der mangelnden CMOS-Kompatibilität zwischen Ferroelektrika und Silicium gelöst wird.

Neben einem Ferroelektrikum als aktives Speichermedium können auch Ionen verwendet werden, welche durch einen Festkörper driften. Je nach Position der Ionen im Material wird das transmittierte Feld durch die Wortleitungen 2 unterschiedlich sein.

Eine Besonderheit des Transmissionsverhaltens durch die Wortleitungen 2 ist, dass sich die Potentialverbiegung nach

$$\frac{d^2\Psi}{dx^2} = \frac{2en}{\varepsilon_0 \varepsilon_r} \cdot sinh\frac{\Psi}{U_T}$$

mit

$\Psi$:    Potential im Festkörper
$U_T$:    Temperaturspannung

extrem nicht-linear verhält.

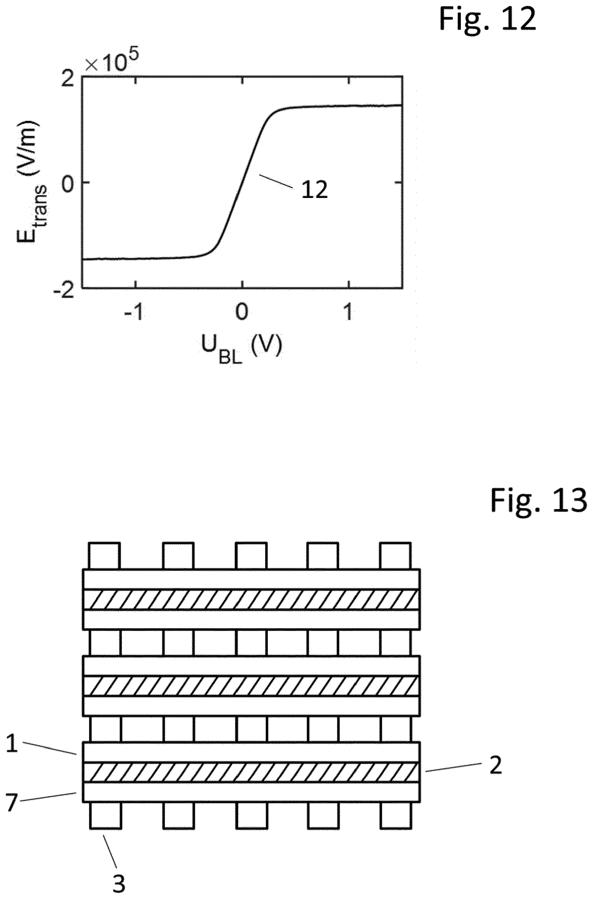

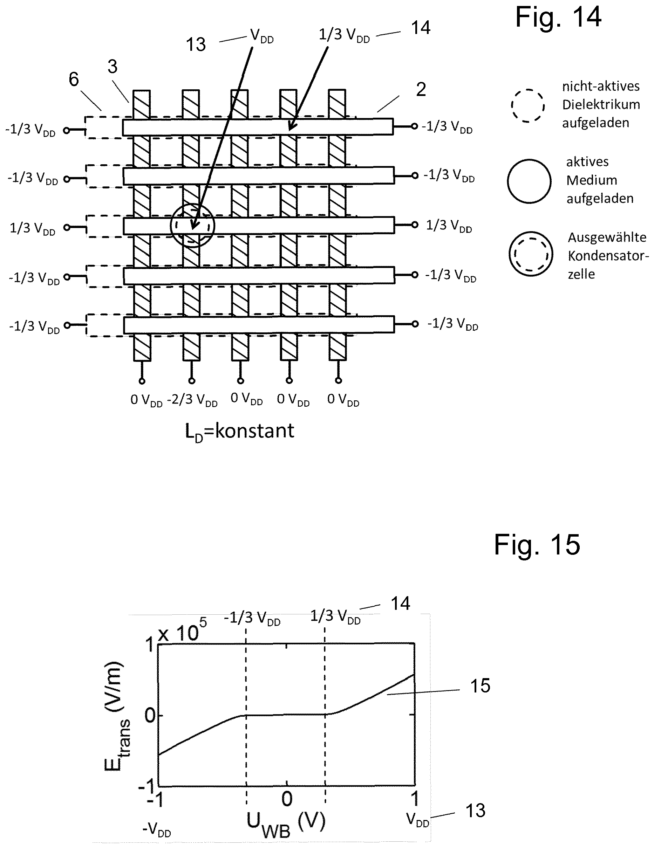

Die oben erwähnte Debye-Länge mit einem exponentiellen Abfall des Potentials oder Feldes durch die Wortleitung 2 gilt nur für relativ kleine Potentiale und Felder und ergibt sich aus einer Linearisierung der oben gezeigten Differentialgleichung. Wird das Feld erhöht, so wird die nicht-Linearität der Differentialgleichung dominant und das transmittierte Feld geht in eine Sättigung. Es ergibt sich zwischen der Bitleitungsspannung $U_{BL} = \Phi_R - \Psi_B$ Potentialdifferenz zwischen Bitleitungspotential und Bezugselektrodenpotential und dem transmittierten Feld eine sigmoidale Beziehung 12, wie dies in Fig. 12 dargestellt ist. Ein Neuron in einem künstlichen neuronalen Netzwerken wiederrum zeigt, wie bereits erwähnt, ein sehr ähnliches Verhalten und es bestünde die Möglichkeit, wie in Anspruch 15 erwähnt, dieses Verhalten zur Modellierung der Aktivierungsfunktion eines Neurons auszunutzen, wobei das aktive Medium mit einer Speicherfunktion die Aufgabe der Synapse erfüllen kann, bzw. die adaptive Einstellmöglichkeit des transmittierten Feldes mit der Debye-Länge auch die synaptische Gewichtung erfüllen kann. Hiermit würden Neuron und Synapse zu einem Bauelement kombiniert werden und keine nachteilige Transistorschaltung wäre mehr nötig, was auch eine dreidimensionale Strukturierung der künstlichen neuronalen Netzwerke vereinfachen würde. Die Nichtlinearität 15 in Fig. 15 kann zur Modellierung von Rectified Linear Units (ReLU) verwendet werden.

Wie in Fig. 13 dargestellt, sind mehrere solcher Matrixvorrichtungen dreidimensional übereinandergestapelt, wobei die Bezugselektrode 6 der einen Matrix gleichzeitig die Bitleitung 3 der darüber liegenden Matrix bildet. Diese Anordnung ist vor allem für Speicheranwendungen vorteilhaft, da so die Speicherdichte erheblich erhöht werden könnte.

Gemäß Fig. 14 bis Fig. 18 kommt eine Anordnung zum Einsatz, die mit Wortleitungen 2 und Bitleitungen 3, welche vorzugsweise senkrecht zueinander angeordnet sind, wobei die Wortleitungen 2 einem Halbleiter mit p-dotierten Gebieten 8 und die Bitleitungen 3 aus einem Halbeleiter mit n-dotierten Gebieten 9 bestehen. Die Höhe der Dotierung ist so gewählt, dass die Fermi-Niveaus der p-Gebiete 8 und der n-dotierten Gebiete 9 einen gleichen Abstand zu dem Fermi-Niveau der Wortleitungen 2 besitzen und das Bändermodell des so entstehenden psn-Überganges 10 eine Symmetrie besitzt.

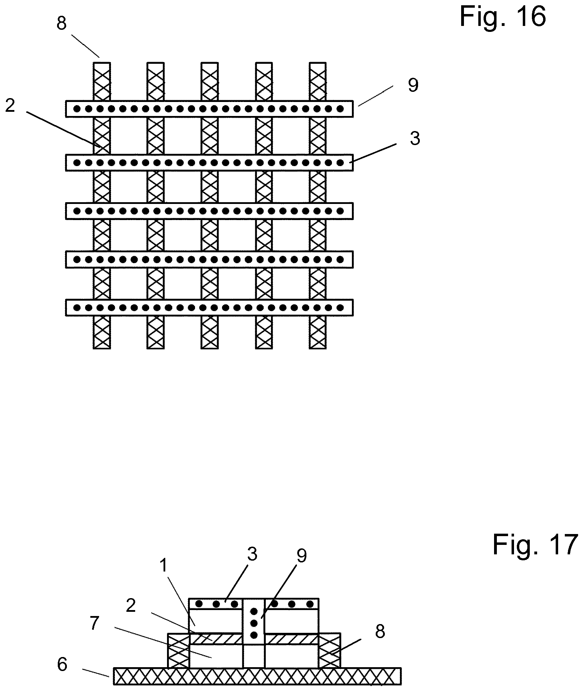

An ihren Kreuzungspunkten sind die Streifenbezugselektrode 6 über das p-dotierte Gebiet 8 und die Bitleitung 3 über das n-dotierte Gebiet 9 jeweils mit der Wortleitung 2 verbunden. Dies wird insbesondere in der Darstellung nach Fig. 17 deutlich.

Die Halbleiter an dem Kreuzungspunkt können z.B. intrinsisch oder schwach dotiert sein, sodass sich pin- bzw. psn-Übergänge ausbilden. Das p-dotierte Gebiet 8 kann hierbei, wie in Fig. 17 gezeigt aus einzelnen Erhebungen entlang des Streifens bestehen und das n-dotierte Gebiet 9 aus einem T-Förmigen Streifen. Das aktive Medium 1 kann dann zwischen dem n-Gebiet 9 und dem p-Gebiet 8 und das nicht-aktive Medium 7 zwischen dem p-Gebiet 8 und n-Gebiet 9 werden. Auch mögliche wäre es, an beiden Stellen ein aktives Medium unterzubringen. In Fig. 17 sind zwei Speicherzellen nebeneinander angeordnet.

Durch die Form der p- und n-Gebiete wirken diese gleichzeitig als Gate- und Streifenbezugselektrode 6, welche das Feld erzeugen. Die Verarmung oder Anreichung des Halbleitergebietes an den Kreuzungspunkten geschieht dabei mit derselben Spannung, wodurch Debye-Länge-Änderung und Spannung zwischen Referenz- 6 und Gateelektrode nicht mehr getrennt eingestellt zu werden braucht. Weiterhin kann durch geschickte Wahl der Spannungen eine punktueller Verarmung oder Anreicherung in der Matrix erreicht werden.

Unabhängig von dem vorstehenden Ausführungsbeispiel kann ein Verfahren zur Anwendung kommen, bei welchem die Bitleitungen 3 und die Streifenbezugselektroden 6 parallel angeordnet sind und die Wortleitungen 2 vorzugsweise senkrecht hierzu angeordnet sind und keine Potentialdfferenz zwischen der Bitleitung 3 und Streifenbezugselektrode 6 vorliegt. Die Debye-Länge in den Wortleitungen 2 wird konstant gehalten und die Potentiale an den Wortleitungen 2, Bitleitungen 3 und Streifenbezugselektroden 6 wird so gewählt, dass die Potentialdifferenz zwischen Bitleitung 3 und Wortleitung 2 an der ausgewählten Kondensatorzelle als volle Spannung 13 vorliegt und an den nicht-ausgewählten Kondensatorzellen 1/3 der vollen Spannung 14 vorliegt und die Nichtlinearität 15 des erzeugten Feldes zur Unterdrückung des Feldes in den nicht-ausgewählten Kondensatorzellen sorgt.

Man kann diese Ansteuerungsweise als eine Art kapazitive Diode auffassen, die ab einer bestimmten Schwellspannung ein elektrisches Feld generiert. Dieser Umstand wird durch Fig. 15 deutlich, da für niedrige Spannungen die Potentialverbiegung im Halbleiter kaum ins Gewicht fällt und das Potential, zwischen Bitleitung 3 und Streifenbezugselektrode 6 weitergeleitet wird. Da zwischen Bitleitung 3 und Streifenbezugselektrode 6 keine Potentialdifferenz vorliegt, bildet sich kein Feld aus. Ab einer bestimmten Schwellspannung ist die Potentialverbiegung im Halbleiter jedoch so groß, dass die Potentialdifferenz zwischen Wortleitung 2 und Bitleitung 3, sowie zwischen Wortleitung 2 und Streifenbezugselektrode 6, ins Gewicht fällt und ein linear ansteigendes elektrisches Feld entsteht. Mit dem üblichen 1/3 Ansatz aus dem Stand der Technik sollten sich somit ein hohes Einschalt- zu Ausschaltverhältnisse ergeben.

Auf diese Weise sind keine Umladungen in der Wortleitung nötig, sodass der Speicher einen geringeren Energieverbrauch und schnellere Zugriffszeiten besitzt.

**Bezugszeichenliste**

| 1 | aktives Medium |
|---|---|
| 2 | Wortleitung |
| 3 | Bitleitung |
| 4 | Kondensatorzelle |
| 5 | ganzflächige Bezugselektrode |
| 6 | Streifenbezugselektrode |
| 7 | nicht-aktives Dielektrikum |
| 8 | p-dotiertes Gebiet |
| 9 | n-dotiertes Gebiet |
| 10 | psn-Übergang |
| 11 | Stromfluss |
| 12 | sigmoidales Übertragungsverhalten |
| 13 | volle Spannung |
| 14 | 1/3 der vollen Spannung |
| 15 | Nichtlinearität |

**Patentansprüche**

1.   Kapazitive Matrixanordnung, umfassend ein aktives Medium (1), das in einer Schicht zwischen einem ersten Satz und einem zweiten Satz von jeweiligen parallelen Adressierungselektroden eingebettet ist, wobei die Adressierungselektroden des ersten Satzes Wortleitungen (2) und die Adressierungselektroden des zweiten Satzes Bitleitungen (3) der Matrixanordnung bilden, wobei sich Wortleitungen (2) und Bitleitungen (3) an Kreuzungspunkten kreuzen und an den Kreuzungspunkten durch Ansteuerung der Wortleitungen (2) und Bitleitungen (3) auswählbare Kondensatorzellen (4) mit dem dazwischenliegenden aktiven Medium (1) angeordnet sind, **dadurch gekennzeichnet, dass** die Wortleitungen (2) zumindest in dem Bereich der Kreuzungspunkte aus einem Material mit veränderlicher Debye-Länge, d.h. einem Material mit veränderlicher beweglicher Ladungsträgerkonzentration, bestehen und zwischen aktivem Medium (1) und einem nicht-aktivem Dielektrikum (7), mit diesen eine Schichtanordnung bildend, angeordnet sind und die Schichtanordnung zwischen einer Bezugselektrode (5, 6) und den Bitleitungen (3) angeordnet ist, wobei

- eine erste Lage der Schichtanordnung so gewählt ist, dass das aktive Medium von der Wortleitung aus gesehen auf der Seite der Bezugselektrode liegt und
- alternativ eine zweite Lage der Schichtanordnung so gewählt ist, dass das aktive Medium von der Wortleitung aus gesehen, auf der Seite der Bitleitungen liegt.

**2.** Kapazitive Matrixanordnung nach Anspruch 1, **dadurch gekennzeichnet, dass** die Bezugselektrode aus mehreren streifenförmigen Streifenbezugselektroden (6) besteht, wobei die Streifenbezugselektroden (6) den Bitleitungen (3) entsprechend ausgebildet und einzeln ansteuerbar sind.

**3.** Kapazitive Matrixanordnung nach Anspruch 1 oder 2,
**dadurch gekennzeichnet, dass** die Wortleitungen (2) aus einem Halbleiter bestehen und mit p- (8) und n-dotierten (9) Gebieten, versehen sind, wobei die Höhe der Dotierung so gewählt wird, dass die Fermi-Niveaus der p- (8) und n-dotierten (9) Gebiete gleichen Abstand zu dem Fermi-Niveau der Wortleitungen (2) besitzen und das Bändermodell des so entstehenden psn-Überganges (10) eine Symmetrie besitzt.

**4.** Kapazitive Matrixanordnung nach Anspruch 3, **dadurch gekennzeichnet, dass** die p-(8) und n-dotierten (9) Gebiete entweder jeweils seitlich Längserstreckung der jeweiligen Wortleitung oder an jeweils einer Stirnseite angeordnet sind.

**5.** Kapazitive Matrixanordnung nach Anspruch 3, **dadurch gekennzeichnet, dass** sich die Streifenbezugselektroden und die Bitleitungen kreuzen und an den Kreuzungspunkten die Streifenbezugselektrode (6) über das p-dotierte Gebiet (8) und die Bitleitung (3) über das n-dotierte Gebiet (9) oder die Streifenbezugselektrode (6) über das n-dotierte Gebiet (9) und die Bitleitung (3) über das p-dotierte Gebiet (8) jeweils mit der Wortleitung (2) verbunden ist.

**6.** Kapazitive Matrixanordnung nach Anspruch 1 oder 2,
**dadurch gekennzeichnet, dass** die Wortleitungen (2) aus einem Halbleiter bestehen und mit unterschiedlichen Metallgebieten, versehen sind, die Schottky-Kontakten ausbilden, wobei die Austrittsarbeit der Metalle so gewählt wird, dass die Abstände der Fermi-Niveaus zwischen den Metallgebieten und dem Halbleiter identisch sind und das Bändermodell symmetrisch ist.

**7.** Kapazitive Matrixanordnung nach Anspruch 1 oder 2,
**dadurch gekennzeichnet, dass** ein Material mit einem Metall-Isolator-Übergang für die Wortleitungen (2) zum Einsatz kommt.

**8.** Kapazitive Matrixanordnung nach einem der Ansprüche 1 bis 7, **dadurch gekennzeichnet, dass** das aktive Medium (1) ein elektrisch polarisierbares dielektrisches Speichermaterial zur Speicherung von Daten ist.

**9.** Kapazitive Matrixanordnung nach einem der Ansprüche 1 bis 7, **dadurch gekennzeichnet, dass** das aktive Medium (1) ein flüssigkeitsbasiertes oder elektrophoretisches Anzeigemittel ist.

**10.** Kapazitive Matrixanordnung nach einem der Ansprüche 1 bis 7, **dadurch gekennzeichnet, dass** die Matrixanordnung eine Modellierung der Aktivierungsfunktion eines künstlichen Neurons mit einem sigmoidalen Transmissionsverhalten (12) der Wortleitungen (2) oder mit einer Nichtlinearität (15) des erzeugten elektrischen Feldes einschließt.

**11.** Verfahren zur Ansteuerung einer kapazitiven Kondensatoranordnung nach einem der vorstehenden Ansprüche, wobei eine an einem Kreuzungspunkt zwischen einer Wortleitung und einer Bitleitung befindliche Kondensatoranordnung durch eine Potentialwahl der dem Kreuzungspunkt entsprechenden auswählenden Wortleitung und der dem Kreuzungspunkt entsprechenden auswählenden Bitleitung ausgewählt wird, **dadurch gekennzeichnet, dass** bei einem Einstellen des Zustandes des aktiven Mediums (1)

    - in der auszuwählenden Kondensatorzelle (4) ein elektrisches Feld (13) erzeugt wird, indem

       • im Falle der ersten Lage der Schichtenordnung eine Potentialdifferenz zwischen auswählender Bitleitung (3) und der Bezugselektrode (5, 6) angelegt wird und das Potential der auswählenden Wortleitung (2) identisch zur Bezugselektrode (5, 6) gewählt wird,
       • oder im Falle der zweiten Lage der Schichtanordnung das Potential der Wortleitung (2) identisch zur Bitleitung (3) gewählt wird, und dass in der auswählenden Wortleitung (2) eine lange Debye-Länge, d.h. eine so niedrige bewegliche Ladungsträgerkonzentration, dass ein genügend starkes Feld transmittiert wird, erzeugt wird, dass in dem aktiven Medium eine Wirkung erzeugt wird, sodass am Kreuzungspunkt zur auswählenden Bitleitung (3) ein elektrisches Feld (13) transmittiert wird, wobei an den nicht-auswählenden Wortleitungen (2) eine kurze Debye-Länge, d.h. eine so hohe bewegliche Ladungsträgerkonzentration erzeugt wird, dass in dem aktiven Medium keine Wirkung erzielt wird, und damit eine schlechte Transmission eingestellt wird,

    - oder zwischen auswählender Bitleitung (3) und Bezugselektrode (5, 6) keine Potentialdifferenz vorliegt, und das Potential der auswählenden Wortleitung (2) unterschiedlich zur Bezugselektrode (5, 6) und Bitleitung (3) gewählt wird und

- • die Debye-Länge der Wortleitung (2) kurz gewählt wird, und die Feldlinien des elektrischen Feldes (13) jeweils hauptsächlich an der Wortleitung (2) enden, sodass in dem aktiven Medium eine Wirkung einsetzt, wobei an die nicht-ausgewählten Wortleitungen (2) eine lange Debye-Länge und eingestellt wird, so dass in dem aktiven Medium keine Wirkung einsetzt oder
- • die Debye-Länge in den Wortleitungen (2) konstant gehalten wird und die Potentiale an den Wortleitungen (2), Bitleitungen (3) und Streifenbezugselektroden (6) so gewählt werden, dass die Potentialdifferenz zwischen Bitleitung (3) und Wortleitung (2) an der ausgewählten Kondensatorzelle als volle Spannung (13) vorliegt und an den nicht-ausgewählten Kondensatorzellen ein Teil, vorzugsweise 1/3 der vollen Spannung (14) vorliegt und die Nichtlinearität (15) des erzeugten Feldes zur Unterdrückung des Feldes in den nicht-ausgewählten Kondensatorzellen sorgt.

und dass bei einem Feststellen des Zustandes des aktiven Mediums (1) in der auszuwählenden Kondensatorzelle (4) ein elektrisches Feld (13) gemessen wird, indem die Potentiale der Bitleitungen (3), der Bezugselektroden (5, 6) und der Wortleitungen (2) identisch gewählt werden und
- im Falle der ersten Lage der Schichtanordnung, ein Strom in der ausgewählten Bitleitung (3) gemessen wird, welcher während der Änderung der Debye-Länge in der ausgewählten Wortleitung (2) erzeugt wird, und
- im Falle der zweiten Lage der Schichtanordnung der Strom in einer dem Kreuzungspunkt entsprechenden Streifenbezugselektrode (6) gemessen wird.

12. Verfahren nach Anspruch 11, **dadurch gekennzeichnet, dass** die Ansteuerung der kompletten Matrix

- im Falle der ersten Lage der Schichtanordnung in der Weise erfolgt, dass bei Vorliegen einer Potentialdifferenz zwischen einer dem Kreuzungspunkt entsprechenden Streifenbezugselektrode (6) und der entsprechenden Bitleitung (3) an die nicht-auswählenden Wortleitungen (2) und nicht-ausgewählten Streifenbezugselektroden (6) ein identisches Potential wie an die auswählende Bitleitung (3) angelegt wird und die nicht-auswählenden Bitleitungen (3) mit identischem Potential wie die entsprechende Streifenbezugselektrode (5, 6) versehen wird, und
- im Falle der zweiten Lage der Schichtanordnung in der Weise erfolgt, dass bei Vorliegen einer Potentialdifferenz zwischen einer dem Kreuzungspunkt entsprechenden Streifenbezugselektrode (6) und der entsprechenden Bitleitung (3) an die nicht-auswählenden Wortleitungen (2) und nicht-auswählenden Bitleitungen (3) ein identisches Potential wie an die entsprechende Streifenbezugselektrode (6) angelegt wird und die anderen Streifenbezugselektroden (6) mit identischem Potential wie die auswählende Bitleitung (3) versehen werden.

13. Verfahren nach Anspruch 11, **dadurch gekennzeichnet, dass** die Ansteuerung der kompletten Matrix in der Weise erfolgt, dass bei Vorliegen keiner Potentialdifferenz zwischen ausgewählter Bitleitung (3) und ausgewählter Streifenbezugselektrode (6), wobei die Streifenbezugselektroden (6) und Bitleitungen (3) parallel angeordnet werden, die nicht-auswählenden Bitleitungen (3) und nicht-auswählenden Streifebezugselektroden (6) auf dasselbe Potential, wie die ausgewählte Wortleitung (2) gelegt werden und das Potential der nicht-auswählenden Wortleitungen (2) beliebig gewählt werden kann.

14. Verfahren nach Anspruch 11 zur Ansteuerung einer Matrixanordnung nach einem der Anspruch 3 bis 5, **dadurch gekennzeichnet, dass** an die psn-Übergänge (10) eine Sperrspannung zur Verarmung der beweglichen Ladungsträgerkonzentration in den Wortleitungen (2) angelegt wird, sofern eine lange Debye-Länge gewünscht wird und eine Durchlassspannung zur Anreicherung der beweglichen Ladungsträgerkonzentration in den Wortleitungen (2) angelegt wird, sofern eine kurze Debye-Länge gewünscht wird, wobei eine antisymmetrische Spannung jeweils an die p- (8) und n-Gebiete (9) angelegt wird.

15. Verfahren nach Anspruch 11 zur Ansteuerung einer Matrixanordnung nach Anspruch 7, **dadurch gekennzeichnet, dass** ein Stromfluss (11) durch die auswählende Wortleitung (2) eine leichte Temperaturerhöhung bewirkt und ein Metall-Isolator-Übergang eine Änderung der beweglichen Ladungsträgerkonzentration in der auswählenden Wortleitung (2) auslöst.

**Claims**

1. A capacitive matrix arrangement, comprising an active medium (1), which is embedded in a layer between a first set and a second set of respective parallel addressing electrodes, wherein the addressing electrodes of the first set form word lines (2) and the addressing electrodes of the second set form bit lines (3) of the matrix arrangement, wherein word lines (2) and bit lines (3) intersect at crossing points and capacitor cells (4) with the intervening active medium (1) are arranged at the crossing points, being selectable by actuation of the word lines (2) and bit lines (3), **characterized in that** the word lines (2) at least in the area of the crossing points consist of a material with variable Debye length, i.e., a material with variable mobile charge carrier concentration, and are arranged between the active medium (1) and a non-active dielectric (7), forming with them a layered arrangement, and the layered arrangement is situated between a reference electrode (5, 6) and the bit lines (3), wherein

- a first layer of the layered arrangement is chosen such that the active medium as seen from the word line is situated on the side with the reference electrode and
- alternatively a second layer of the layered arrangement is chosen such that the active medium as seen from the word line is situated on the side with the bit lines.

2. The capacitive matrix arrangement as claimed in claim 1, **characterized in that** the reference electrode consists of multiple striplike strip reference electrodes (6), wherein the strip reference electrodes (6) are formed corresponding to the bit lines (3) and are individually actuable.

3. The capacitive matrix arrangement as claimed in claim 1 or 2, **characterized in that** the word lines (2) consist of a semiconductor and are provided with p-doped (8) and n-doped (9) regions, wherein the level of the doping is chosen such that the Fermi levels of the p-doped (8) and n-doped (9) regions have the same distance from the Fermi level of the word lines (2) and the band model of the resulting psn-junction (10) possesses symmetry.

4. The capacitive matrix arrangement as claimed in claim 3, **characterized in that** the p-doped (8) and n-doped (9) regions are situated either to the side of the longitudinal extension of the respective word line or at an end face.

5. The capacitive matrix arrangement as claimed in claim 3, **characterized in that** the strip reference electrodes and the bit lines cross each other and at the crossing points the strip reference electrode (6) is connected to the word line (2) across the p-doped region (8) and the bit line (3) across the n-doped region (9) or the strip reference electrode (6) is connected across the n-doped region (9) and the bit line (3) across the p-doped region (8), respectively.

6. The capacitive matrix arrangement as claimed in claim 1 or 2, **characterized in that** the word lines (2) consist of a semiconductor and are provided with different metal regions forming the Schottky contacts, wherein the work function of the metals is chosen such that the distances of the Fermi levels between the metal regions and the semiconductor are identical and the band model is symmetrical.

7. The capacitive matrix arrangement as claimed in claim 1 or 2, **characterized in that** a material with a metal-insulator junction is used for the word lines (2).

8. The capacitive matrix arrangement as claimed in one of claims 1 to 7, **characterized in that** the active medium (1) is an electrically polarizable dielectric storage material for the storage of data.

9. The capacitive matrix arrangement as claimed in one of claims 1 to 7, **characterized in that** the active medium (1) is a liquid-based or electrophoretic display means.

10. The capacitive matrix arrangement as claimed in one of claims 1 to 7, **characterized in that** the matrix arrangement involves a modeling of the activation function of an artificial neuron with a sigmoidal transmission behavior (12) of the word lines (2) or with a nonlinearity (15) of the generated electric field.

11. A method for the actuation of a capacitive capacitor arrangement as claimed in one of the preceding claims, wherein a capacitor arrangement situated at a crossing point between a word line and a bit line is selected by a potential selection of the word line being selected and corresponding to the crossing point and the bit line being selected and corresponding to the crossing point, **characterized in that** when setting the state of the active medium (1)

- an electric field (13) is generated in the capacitor cell (4) being selected by

• applying a potential difference between the bit line (3) being selected and the reference electrode (5, 6) in the case of the first layer of the layered arrangement and selecting the potential of the word line (2) being selected to be identical to the reference electrode (5, 6),
• or, in the case of the second layer of the layered arrangement, by selecting the potential of the word line (2) to be identical to the bit line (3), and by generating in the word line (2) being selected a long Debye-length, i.e., a mobile charge carrier concentration which is so low that a sufficiently strong field is transmitted, producing an action in the active medium such that an electric field (13) is transmitted at the crossing point to the bit line (3) being selected, while at the word lines (2) not being selected a short Debye-length is generated, i.e., a mobile charge carrier concentration which is so high that no action is produced in the active medium, and thus a poor transmission is established,

- or no potential difference is present between the bit line (3) being selected and the reference electrode (5, 6), and the potential of the word line (2) being selected is chosen to be different from the reference electrode (5, 6) and the bit line (3), and

• the Debye-length of the word line (2) is chosen to be short, and the field lines of the electric field (13) respectively end principally at the word line (2), so that an action is produced in the active medium, wherein a long Debye-length is established at the word lines (2) not selected, so that no action is produced in the active medium, or
• the Debye-length in the word lines (2) is held constant and the potentials on the word lines (2), bit lines (3) and strip reference electrodes (6) are chosen to be such that the potential difference between bit line (3) and word line (2) at the selected capacitor cell is present as the full voltage (13) and at the capacitor cells not selected a portion of the full voltage (14) is present, preferably 1/3, and the nonlinearity (15) of the generated field ensures the suppression of the field in the capacitor cells not selected,

and when determining the state of the active medium (1) in the capacitor cell (4) being selected, an electric field (13) is measured by choosing the potentials of the bit lines (3), the reference electrodes (5, 6) and the word lines (2) to be identical, and
- in the case of the first layer of the layered arrangement, a current is measured in the selected bit line (3) that is generated during the changing of the Debye-length in the selected word line (2), and
- in the case of the second layer of the layered arrangement, the current is measured in a strip reference electrode (6) corresponding to the crossing point.

12. The method as claimed in claim 11, **characterized in that** the actuation of the complete matrix

- in the case of the first layer of the layered arrangement, is done in such a way that, when a potential difference is present between a strip reference electrode (6) corresponding to the crossing point and the corresponding bit line (3), an identical potential to that of the bit line (3) being selected is applied to the word lines (2) not being selected and the strip reference electrodes (6) not selected, and the bit lines (3) not being selected are provided with an identical potential to the corresponding strip reference electrode (5, 6), and
- in the case of the second layer of the layered arrangement, it is done in such a way that, when a potential difference is present between a strip reference electrode (6) corresponding to the crossing point and the corresponding bit line (3), an identical potential to the corresponding strip reference electrode (6) is applied to the word lines (2) not being selected and the bit lines (3) not being selected, and the other strip reference electrodes (6) are provided with the identical potential to that of the bit line (3) being selected.

13. The method as claimed in claim 11, **characterized in that** the actuation of the complete matrix occurs in such a way that, when no potential difference is present between the selected bit line (3) and selected strip reference electrode (6), with the strip reference electrodes (6) and bit lines (3) being arranged in parallel, the bit lines (3) not being selected and the strip reference electrodes (6) not being selected are placed at the same potential as the selected word line (2) and the potential of the word lines (2) not being selected can be chosen arbitrarily.

14. The method as claimed in claim 11 for the actuation of the matrix arrangement as claimed in one of claims 3 to 5, **characterized in that** a blocking voltage is applied to the psn-junctions (10) to deplete the mobile charge carrier concentration in the word lines (2), insofar as a long Debye-length is desired, and a forward voltage is applied to enrich the mobile charge carrier concentration in the word lines (2), insofar as a short Debye-length is desired, each time applying an antisymmetrical voltage to the p-regions (8) and n-regions (9).

15. The method as claimed in claim 11 for the actuation of the matrix arrangement as claimed claim 7, **characterized in that** a current flow (11) through the word line (2) being selected produces a slight temperature rise and a metal-insulator junction triggers a change in the mobile charge carrier concentration in the word line (2) being selected.

## Revendications

1. Arrangement matriciel capacitif, comprenant un milieu actif (1), qui est enrobé dans une couche entre un premier jeu et un deuxième jeu d'électrodes d'adressage respectivement parallèles, les électrodes d'adressage du premier jeu formant les lignes de mot (2) et les électrodes d'adressage du deuxième jeu formant les lignes de bit (3) de l'arrangement matriciel, les lignes de mot (2) et les lignes de bit (3) se croisant en des points d'intersection et des cellules de condensateur (4) entre lesquelles se trouve le milieu actif (1) étant disposées au niveau des points d'intersection par pilotage des lignes de mot (2) et des lignes de bit (3), **caractérisé en ce que** les lignes de mot (2), au moins dans la zone des points d'intersection, se composent d'un matériau ayant une longueur de Debye variable, c'est-à-dire d'un matériau ayant une concentration de porteurs de charge mobiles variable, et sont disposées entre le milieu actif (1) et un diélectrique (7) non actif, en formant avec ceux-ci un arrangement stratifié, et l'arrangement stratifié est disposé entre une électrode de référence (5, 6) et les lignes de bit (3),

    - une première couche de l'arrangement stratifié étant choisie de telle sorte que le milieu actif, vu depuis la ligne de mot, se trouve du côté de l'électrode de référence et
    - en variante, une deuxième couche de l'arrangement stratifié étant choisie de telle sorte que le milieu actif, vu depuis la ligne de mot, se trouve du côté des lignes de bit.

2. Arrangement matriciel capacitif selon la revendication 1, **caractérisé en ce que** l'électrode de référence se compose de plusieurs électrodes de référence en bande (6) en forme de bande, les électrodes de référence en bande (6) étant configurées en correspondance avec les lignes de bit (3) et pouvant être pilotées individuellement.

3. Arrangement matriciel capacitif selon la revendication 1 ou 2, **caractérisé en ce que** les lignes de mot (2) se composent d'un semiconducteur et sont pourvues de régions dopées p (8) et dopées n (9), le niveau de dopage étant choisi de telle sorte que les niveaux de Fermi des régions dopées p (8) et dopées n (9) possèdent le même écart du niveau de Fermi des lignes de mot (2) et le modèle des bandes énergétiques de la transition psn (10) ainsi produit présente une symétrie.

4. Arrangement matriciel capacitif selon la revendication 3, **caractérisé en ce que** les régions dopées p (8) et dopées n (9) sont soit respectivement une extension longitudinale latérale de la ligne de mot respective, soit disposées respectivement au niveau d'un côté frontal.

5. Arrangement matriciel capacitif selon la revendication 3, **caractérisé en ce que** les électrodes de référence en bande et les lignes de bit se croisent et, au niveau des points d'intersection, une liaison est respectivement établie avec la ligne de mot (2) de l'électrode de référence en bande (6) par le biais de la région dopée p (8) et de la ligne de bit (3) par le biais de la région dopée n (9) ou de l'électrode de référence en bande (6) par le biais de la région dopée n (9) et de la ligne de bit (3) par le biais de la région dopée p (8).

6. Arrangement matriciel capacitif selon la revendication 1 ou 2, **caractérisé en ce que** les lignes de mot (2) se composent d'un semiconducteur et sont pourvues de différentes régions métalliques, lesquelles forment des contacts Schottky, le travail d'extraction des métaux étant choisi de telle sorte que les niveaux de Fermi entre les régions métalliques et le semiconducteur sont identiques et le modèle des bandes énergétiques est symétrique.

7. Arrangement matriciel capacitif selon la revendication 1 ou 2, **caractérisé en ce qu'**un matériau ayant une transition métal-isolateur est employé pour les lignes de mot (2).

8. Arrangement matriciel capacitif selon l'une des revendications 1 à 7, **caractérisé en ce que** le milieu actif (1) est un matériau de mémoire diélectrique polarisable électriquement servant à la mémorisation de données.

9. Arrangement matriciel capacitif selon l'une des revendications 1 à 7, **caractérisé en ce que** le milieu actif (1) est un moyen d'affichage à base de liquide ou à électrophorèse.

10. Arrangement matriciel capacitif selon l'une des revendications 1 à 7, **caractérisé en ce que** l'arrangement matriciel inclut une modélisation de la fonction d'activation d'un neurone artificiel avec un comportement de transmission sigmoïdal (12) des lignes de mot (2) ou avec une non-linéarité (15) du champ électrique généré.

11. Procédé de pilotage d'un arrangement matriciel capacitif selon l'une des revendications précédentes, un arrangement de condensateur qui se trouve au niveau d'un point d'intersection entre une ligne de mot et une ligne de bit étant sélectionné par une sélection de potentiel de la ligne de mot qui réalise la sélection correspondant au point d'intersection et de la ligne de bit qui réalise la sélection correspondant au point d'intersection, **caractérisé en ce que** lors d'un réglage de l'état du milieu actif (1)

- un champ électrique (13) est généré dans la ligne de condensateur (4) à sélectionner par

　　* dans le cas de la première couche de l'arrangement stratifié, application d'une différence de potentiel entre la ligne de bit (3) qui réalise la sélection et l'électrode de référence (5, 6) et sélection du potentiel de la ligne de mot (2) qui réalise la sélection identique à celui de l'électrode de référence (5, 6),
　　* ou dans le cas de la deuxième couche de l'arrangement stratifié, sélection du potentiel de la ligne de mot (2) identique à celui de la ligne de bit (3), et génération, dans la ligne de mot (2) qui réalise la sélection, d'une longueur de Debye longue, c'est-à-dire d'une concentration de porteurs de charge mobiles faible au point qu'un champ suffisamment puissant soit transmis pour qu'un effet soit généré dans le milieu actif, de sorte qu'un champ électrique (13) soit transmis vers la ligne de bit (3) qui réalise la sélection au niveau du point d'intersection, une longueur de Debye courte au niveau des lignes de mot (2) qui ne réalisent pas la sélection est généré, c'est-à-dire une concentration de porteurs de charge mobiles élevée au point qu'aucun effet n'est obtenu dans le milieu actif, et ainsi qu'une mauvaise transmission soit établie,

- ou aucune différence de potentiel n'est présente entre la ligne de bit (3) qui réalise la sélection et l'électrode de référence (5, 6), et le potentiel de la ligne de mot (2) qui réalise la sélection est choisi différent de celui de l'électrode de référence (5, 6) et de la ligne de bit (3) et

　　* la longueur de Debye de la ligne de mot (2) est choisie courte et les lignes de champ du champ électrique (13) se terminent respectivement principalement au niveau de la ligne de mot (2), de sorte qu'un effet s'établit dans le milieu actif, une longueur de Debye longue étant réglée au niveau des lignes de mot (2) non sélectionnées, de sorte qu'aucun effet s'établit dans le milieu actif ou
　　* la longueur de Debye dans les lignes de mot (2) est maintenue constante et les potentiels au niveau des lignes de mot (2), des lignes de bit (3) et des électrodes de référence en bande (6) sont choisis de telle sorte que la différence de potentiel entre la ligne de bit (3) et la ligne de mot (2) au niveau de la cellule de condensateur sélectionnée est présente en tant que la tension complète (13) et une partie, de préférence 1/3 de la tension complète (14), est présente au niveau des cellules de condensateur non sélectionnées et la non-linéarité (15) du champ généré contribue à inhiber le champ dans les cellules de condensateur non sélectionnées,

et **en ce que** lors d'une constatation de l'état du milieu actif (1) dans la cellule de condensateur (4) à sélectionner, un champ électrique (13) est mesuré en choisissant les potentiels des lignes de bit (3), des électrodes de référence (5, 6) et des lignes de mot (2) identiques et
- dans le cas de la première couche de l'arrangement stratifié, un courant est mesuré dans la ligne de bit (3) sélectionnée, lequel est généré pendant la modification de la longueur de Debye dans la ligne de mot (2) sélectionnée, et
- dans le cas de la deuxième couche de l'arrangement stratifié, le courant est mesuré dans une électrode de référence en bande (6) correspondant au point d'intersection.

12. Procédé selon la revendication 11, **caractérisé en ce que** le pilotage de la matrice complète

　　- dans le cas de la première couche de l'arrangement stratifié, s'effectue de manière à ce qu'en présence d'une différence de potentiel entre une électrode de référence en bande (6) correspondant au point d'intersection et la ligne de bit (3) correspondante, un potentiel identique à celui de la ligne de bit (3) qui réalise la sélection est appliqué au niveau des lignes de mot (2) qui ne réalisent pas la sélection et des électrodes de référence en bande (6) non sélectionnées et les lignes de bit (3) qui ne réalisent pas la sélection sont pourvues d'un potentiel identique à celui de l'électrode de référence en bande (5, 6) correspondante
　　- dans le cas de la deuxième couche de l'arrangement stratifié, s'effectue de manière à ce qu'en présence d'une différence de potentiel entre une électrode de référence en bande (6) correspondant au point d'intersection et la ligne de bit (3) correspondante, un potentiel identique à celui de l'électrode de référence en bande (6) correspondante est appliqué au niveau des lignes de mot (2) qui ne réalisent pas la sélection et des lignes de bit (3) non sélectionnées et les autres électrodes de référence en bande (6) sont pourvues d'un potentiel identique à celui de la ligne de bit (3) qui réalise la sélection.

13. Procédé selon la revendication 11, **caractérisé en ce que** le pilotage de la matrice complète s'effectue de manière à ce qu'en présence d'aucune différence de potentiel entre la ligne de bit (3) qui réalise la sélection et l'électrode de référence en bande (6) sélectionnée, les électrodes de référence en bande (6) et les lignes de bit (3) étant disposées en parallèle, les lignes de bit (3) qui ne réalisent pas la sélection et les électrodes de référence en bande (6) qui ne réalisent pas la sélection sont mises au même potentiel que la ligne de mot (2) sélectionnée et le potentiel des lignes de mot (2) qui ne réalisent pas la sélection peut être choisi à volonté.

14. Procédé selon la revendication 11 de pilotage d'un arrangement matriciel selon l'une des revendications 3 à 5, **caractérisé en ce qu'**une tension de blocage destinée à appauvrir la concentration de porteurs de charge mobiles dans les lignes de mot (2) est appliquée au niveau des transitions psn (10), à condition qu'une longueur de Debye longue soit souhaitée, et une tension de passage destinée à enrichir la concentration de porteurs de charge mobiles dans les lignes de mot (2) est appliquée à condition qu'une longueur de Debye courte soit souhaitée, une tension antisymétrique étant appliquée respectivement au niveau de la région p (8) et (9).

15. Procédé selon la revendication 11 de pilotage d'un arrangement matriciel selon la revendication 7, **caractérisé en ce qu'**un flux de courant (11) à travers la ligne de mot (2) qui réalise la sélection produit une légère augmentation de la température et une transition métal-isolateur déclenche une modification de la concentration de porteurs de charge mobiles dans la ligne de mot (2) qui réalise la sélection.

Fig. 1

Fig. 2

Fig. 3

Fig. 4

Fig. 5

Ausgewählte Wortleitung:                    Nicht-ausgewählte Wortleitung:

$\phi_R \neq \phi_B$                         $\phi_R \neq \phi_B$

$\phi_W = \phi_R$                            $\phi_W = \phi_R$

$\phi_B$                                     $\phi_B$

Debye-Länge lang                            Debye-Länge kurz

# Fig. 6

Ausgewählte Wortleitung:

$$\phi_R = \phi_B$$

5,6

1

13

2

7

$\phi_W \neq \phi_R$

3

$$\phi_B$$

Debye-Länge kurz

Nicht-ausgewählte Wortleitung:

$$\phi_R = \phi_B$$

5,6

1

2

7

$\phi_W = \text{beliebig}$

3

$$\phi_B$$

Debye-Länge lang

# Fig. 7

$$\phi_R = \phi_B = \phi_W$$

6

1

13

2

7

$\phi_W = \phi_R = \phi_B$

3

Sensorstrom

Debye-Länge ändern

Fig. 8

3

6

$\Phi_B$   $\Phi_R \neq \Phi_B$   $\Phi_B$   $\Phi_B$   $\Phi_B$

$\Phi_R$

$\Phi_R$

$\Phi_B$

$\Phi_R$

$\Phi_R$

2

$\Phi_B$   $\Phi_W = \Phi_R$   $\Phi_B$   $\Phi_B$   $\Phi_B$

$L_D\downarrow$   $L_D\uparrow$   $L_D\downarrow$   $L_D\downarrow$   $L_D\downarrow$

nicht-aktives
Dielektrikum
aufgeladen

aktives
Medium
aufgeladen

Ausgewählte
Kondensatorzelle

Fig. 9

3   2   6

$\Phi_W$   $\Phi_W$

$\Phi_W$   $\Phi_W$

$\Phi_B$   $\Phi_R = \Phi_B$

$\Phi_W$   $\Phi_W$

$\Phi_W$   $\Phi_W$

bel.   $\Phi_W \neq \Phi_B$   bel.   bel.   bel.

$L_D\uparrow$   $L_D\downarrow$   $L_D\uparrow$   $L_D\uparrow$   $L_D\uparrow$

nicht-aktives
Dielektrikum
aufgeladen

aktives
Medium
aufgeladen

Ausgewählte
Kondensatorzelle

Fig. 10a

Fig. 10b

Fig. 11

Fig. 12

Fig. 13

## Fig. 14

L_D=konstant

**Legende:**

nicht-aktives Dielektrikum aufgeladen

aktives Medium aufgeladen

Ausgewählte Kondensator-zelle

## Fig. 15

Fig. 16

Fig. 17

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1316090 B1
- EP 1798732 A1
- US 20060046344 A1
- US 20020017667 A1
- US 20030137865 A1
- US 20110090443 A1
- US 20080043317 A1
- US 5583688 A
- US 20060002168 A1

- WO 200385675 A2
- US 20030053351 A1
- US 6438019 B
- US 5088060 A
- US 7616497 B
- US 3476954 A
- US 8694452 B
- DE 102010045363 B4
- US 20080037324 A1

**In der Beschreibung aufgeführte Nicht-Patentliteratur**

- **WILLEM DEN BOER.** Active Matrix Liquid Crystal Displays. Fundamentals and Applications. Elsevier, 2005
- **TEMKAR N. RUCKMONGATHAN.** Addressing Techniques of Liquid Crystal Displays. Wiley, 2014

- **BETTY PRINCE.** Semiconductor Memories: A Handbook of Design, Manufacture and Application. Wiley, 1995